# EUROPEAN PATENT APPLICATION

(11) **EP 4 369 882 A1**
(43) Date of publication of application: **15.05.2024**
(21) Application number: 23199237.1
(22) Date of filing: 22.09.2023
(51) Int. Cl.: H10B 43/27, H10B 43/40, H10B 43/50

(54) **THREE-DIMENSIONAL SEMICONDUCTOR MEMORY DEVICE AND ELECTRONIC SYSTEM INCLUDING THE SAME**

(30) Priority: 14.11.2022 KR 20220152031
(71) Applicant: Samsung Electronics Co., Ltd., Suwon-si, Gyeonggi-do 16677 (KR)
(72) Inventor: KIM, Jiwon, 16677 Suwon-si (KR); KIM, Jiyoung, 16677 Suwon-si (KR); YANG, Woosung, 16677 Suwon-si (KR); KIM, Dohyung, 16677 Suwon-si (KR); SUNG, Sukkang, 16677 Suwon-si (KR)
(74) Representative: Marks & Clerk LLP

(57) **Abstract**

Disclosed are 3D semiconductor memory devices and electronic systems including the same. The 3D semiconductor memory device comprises a first substrate, a peripheral circuit structure on the first substrate, and a cell array structure on the peripheral circuit structure. The cell array structure includes a second substrate, a stack structure between the second substrate and the peripheral circuit structure and including interlayer dielectric layers and conductive patterns that are stacked alternately with the interlayer dielectric layers, vertical channel structures that include respective portions the stack structure and include vertical semiconductor patterns, respectively, and connection vias that include respective portions the second substrate and are connected to respective top surfaces of the vertical semiconductor patterns.

## Description

### BACKGROUND

The present inventive concepts relate to a three-dimensional semiconductor memory device, a method of fabricating the same, and an electronic system including the same, and more particularly, to a three-dimensional semiconductor memory device including a peripheral circuit structure and a cell array structure that are bonded to each other through bonding pads, a method of fabricating the same, and an electronic system including the same.

It may be beneficial to have a semiconductor device capable of storing a large amount of data in an electronic system which requires data storage. Semiconductor devices have been highly integrated to meet high performance and low manufacturing cost. Integration of two-dimensional or planar semiconductor devices may be determined by the area occupied by a unit memory cell, such that it may be greatly influenced by the level of technology for forming fine patterns. However, the extremely expensive processing equipment used to increase pattern fineness may set a practical limitation on increasing the integration of the two-dimensional or planar semiconductor devices. Therefore, three-dimensional semiconductor memory devices having three-dimensionally arranged memory cells have been proposed.

### SUMMARY

Some embodiments of the present inventive concepts provide a three-dimensional semiconductor memory device whose reliability and electrical properties are improved and a method of fabricating the same.

Some embodiments of the present inventive concepts provide a three-dimensional semiconductor memory device and a method of fabricating the same, which method is capable of achieving process simplicity.

An object of the present inventive concepts is not limited to the mentioned above, and other objects which have not been mentioned above will be clearly understood to those skilled in the art from the following description.

According to some embodiments of the present inventive concepts, a three-dimensional semiconductor memory device may comprise: a first substrate; a peripheral circuit structure on the first substrate; and a cell array structure on the peripheral circuit structure. The cell array structure may include: a second substrate; a stack structure between the second substrate and the peripheral circuit structure, the stack structure including a plurality of interlayer dielectric layers and a plurality of conductive patterns that are stacked alternately with the plurality of interlayer dielectric layers; a plurality of vertical channel structures that include respective portions in the stack structure and include a plurality of vertical semiconductor patterns, respectively; and a plurality of connection vias that include respective portions in the second substrate and are connected to respective top surfaces of the plurality of vertical semiconductor patterns.

According to some embodiments of the present inventive concepts, a three-dimensional semiconductor memory device may comprise: a first substrate; a peripheral circuit structure on the first substrate; and a cell array structure on the peripheral circuit structure. The cell array structure may include: a second substrate; a stack structure between the second substrate and the peripheral circuit structure, the stack structure including a plurality of interlayer dielectric layers and a plurality of conductive patterns that are stacked alternately with the plurality of interlayer dielectric layers; a plurality of vertical channel structures that include respective portions the stack structure and include a plurality of vertical semiconductor patterns; a plurality of connection vias that penetrate the second substrate and are connected to respective top surfaces of the plurality of vertical semiconductor patterns; a plurality of cell contact plugs that are connected to the plurality of conductive patterns, respectively; a plurality of bit lines connected to the cell contact plugs; a plurality of source vias that include respective portions in the second substrate; and a common source line on the second substrate and connected to the source vias.

According to some embodiments of the present inventive concepts, an electronic system may comprise: a three-dimensional semiconductor memory device that includes a first substrate, a peripheral circuit structure on the first substrate, and a cell array structure on the peripheral circuit structure, the cell array structure including a cell array area and a cell array contact area; and a controller electrically connected through an input/output pad to the three-dimensional semiconductor memory device, the controller being configured to control the three-dimensional semiconductor memory device. The cell array structure may include: a second substrate; a stack structure between the second substrate and the peripheral circuit structure, the stack structure including a plurality of interlayer dielectric layers and a plurality of conductive patterns that are stacked alternately with the plurality of interlayer dielectric layers; a plurality of vertical channel structures that include respective portions in the stack structure and include, respectively, a plurality of vertical semiconductor patterns; and a plurality of connection vias that include respective portions in the second substrate and are connected to respective top surfaces of the plurality of vertical semiconductor patterns.

At least some of the above and other features of the invention are set out in the claims.

### BRIEF DESCRIPTION OF THE DRAWINGS

FIG. 1 is a simplified block diagram of an electronic system that includes a three-dimensional semiconductor memory device according to some embodiments of the present inventive concepts.
FIG. 2 is a simplified perspective view of an electronic system that includes a three-dimensional semiconductor memory device according to some embodiments of the present inventive concepts.
FIGS. 3 and 4 are cross-sectional views respectively taken along lines I-I' and II-II' of FIG. 2 according to some embodiments of the present inventive concepts.
FIG. 5 is a plan view of a three-dimensional semiconductor memory device according to some embodiments of the present inventive concepts.
FIGS. 6A and 6B are cross-sectional views respectively taken along lines I-I' and II-II' of FIG. 5 according to some embodiments of the present inventive concepts.
FIGS. 7A and 7B are enlarged views showing section Q of FIG. 6 according to some embodiments of the present inventive concepts.
FIGS. 7C and 7D illustrate cross-sectional views showing a structural difference between vertical channel structures which will be discussed below.
FIG. 8 is a cross-sectional view taken along line I-I' of FIG. 5 according to some embodiments of the present inventive concepts.
FIGS. 9A and 12A, 13A, 14A and 15A are cross-sectional views taken along line I-I' of FIG. 5 illustrating a method of fabricating a three-dimensional semiconductor memory device according to some embodiments of the present inventive concepts.
FIGS. 9B and 12B, 13B, 14B and 15B are cross-sectional views taken along line II-II' of FIG. 5 illustrating a method of fabricating a three-dimensional semiconductor memory device according to some embodiments of the present inventive concepts.
FIGS. 10A and 11A are cross-sectional views taken along line III-III' of FIG. 5 illustrating a method of fabricating a three-dimensional semiconductor memory device according to some embodiments of the present inventive concepts.
FIGS. 10B and 11B are cross-sectional views taken along line IV-IV' of FIG. 5 illustrating a method of fabricating a three-dimensional semiconductor memory device according to some embodiments of the present inventive concepts.

### DETAIL PARTED DESCRIPTION

The following will now describe in detail a three-dimensional semiconductor memory device, a method of fabricating the same, and an electronic system including the same according to some embodiments of the present inventive concepts in conjunction with the accompanying drawings.

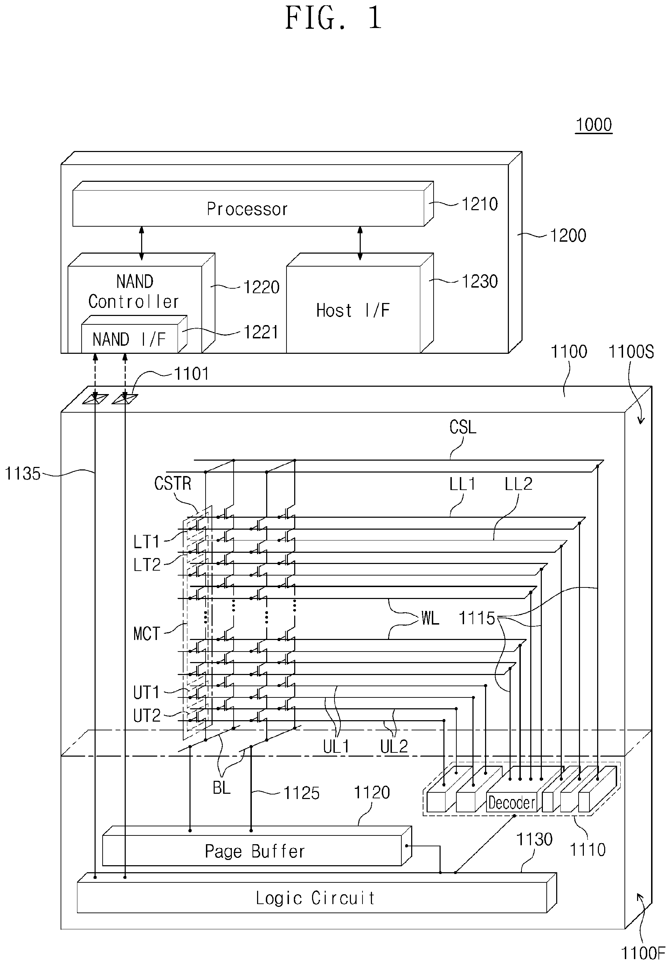

FIG. 1 is a simplified block diagram of an electronic system that includes a three-dimensional semiconductor memory device according to some example embodiments of the present inventive concepts.

Referring to FIG. 1, an electronic system 1000 according to some embodiments of the present inventive concepts may include a three-dimensional semiconductor memory device 1100 and a controller 1200 electrically connected to the three-dimensional semiconductor memory device 1100. The electronic system 1000 may be a storage device that includes a single or a plurality of three-dimensional semiconductor memory devices 1100 or may be an electronic device that includes the storage device. For example, the electronic system 1000 may be a solid state drive (SSD) device, a universal serial bus (USB), a computing system, a medical apparatus, or a communication apparatus, each of which includes a single or a plurality of three-dimensional semiconductor memory devices 1100.

The three-dimensional semiconductor memory device 1100 may be a nonvolatile memory device, such as a three-dimensional NAND Flash memory device which will be discussed below. The three-dimensional semiconductor memory device 1100 may include a first region 1100F and a second region 1100S on the first region 1100F. In some embodiments, differently from that shown, the first region 1100F may be disposed on a side of the second region 1100S. The first region 1100F may be a peripheral circuit region that includes a decoder circuit 1110, a page buffer 1120, and a logic circuit 1130. The second region 1100S may be a memory cell region that includes bit lines BL, a common source line CSL, word lines WL, first lines LL1 and LL2, second lines UL1 and UL2, and memory cell strings CSTR between the bit lines BL and the common source line CSL.

On the second region 1100S, each of the memory cell strings CSTR may include first transistors LT1 and LT2 adjacent to the common source line CSL, second transistors UT1 and UT2 adjacent to the bit line BL, and a plurality of memory cell transistors MCT disposed between the first transistors LT1 and LT2 and the second transistors UT1 and UT2. The number of the first transistors LT1 and LT2 and of the second transistors UT1 and UT2 may be variously changed in accordance with embodiments. The memory cell strings CSTR may be positioned between the common source line CSL and the first region 1100F.

For example, the second transistors UT1 and UT2 may include a string selection transistor, and the first transistors LT1 and LT2 may include a ground selection transistor. The first lines LL1 and LL2 may be gate electrodes of the first transistors LT1 and LT2, respectively. The word lines WL may be gate electrodes of the memory cell transistors MCT, and the second lines UL1 and UL2 may be gate electrodes of the second transistors UT1 and UT2.

The common source line CSL, the first lines LL1 and LL2, the word lines WL, and the second lines UL1 and UL2 may be electrically connected to the decoder circuit 1110 through first connection lines 1115 that extend from the first region 1100F toward the second region 1100S. The bit lines BL may be electrically connected to the page buffer 1120 through second connection lines 1125 that extend from the first region 1100F toward the second region 11005.

On the first region 1100F, the decoder circuit 1110 and the page buffer 1120 may perform a control operation to at least one selected memory cell transistor among the plurality of memory cell transistors MCT. The logic circuit 1130 may control the decoder circuit 1110 and the page buffer 1120. The three-dimensional semiconductor memory device 1100 may communicate with the controller 1200 through an input/output pad 1101 electrically connected to the logic circuit 1130. The input/output pad 1101 may be electrically connected to the logic circuit 1130 through an input/output connection line 1135 that extends from the first region 1100F toward the second region 1100S.

The controller 1200 may include a processor 1210, a NAND controller 1220, and a host interface 1230. According to some embodiments, the electronic system 1000 may include a plurality of three-dimensional semiconductor memory devices 1100, and in this case, the controller 1200 may control the plurality of three-dimensional semiconductor memory devices 1100.

The processor 1210 may control an overall operation of the electronic system 1000 that includes the controller 1200. The processor 1210 may operate based on certain firmware, and may control the NAND controller 1220 to access the three-dimensional semiconductor memory device 1100. The NAND controller 1220 may include an NAND interface 1221 that processes communication with the three-dimensional semiconductor memory device 1100. The NAND interface 1221 may be used to transfer therethrough a control command which is intended to control the three-dimensional semiconductor memory device 1100, data which is intended to be written on the memory cell transistors MCT of the three-dimensional semiconductor memory device 1100, and/or data which is intended to be read from the memory cell transistors MCT of the three-dimensional semiconductor memory device 1100. The host interface 1230 may provide the electronic system 1000 with communication with an external host. When a control command is received through the host interface 1230 from an external host, the three-dimensional semiconductor memory device 1100 may be controlled by the processor 1210 in response to the control command.

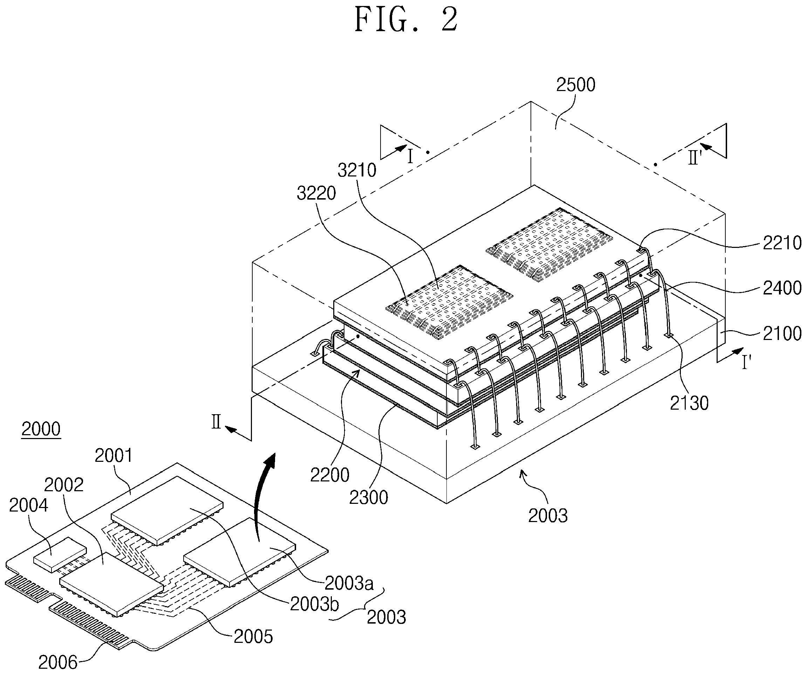

FIG. 2 is a simplified perspective view of an electronic system that includes a three-dimensional semiconductor memory device according to some embodiments of the present inventive concepts.

Referring to FIG. 2, an electronic system 2000 according to some example embodiments of the present inventive concepts may include a main board 2001, a controller 2002 mounted on the main board 2001, one or more semiconductor packages 2003, and a dynamic random access memory (DRAM) 2004. The semiconductor package 2003 and the DRAM 2004 may be connected to the controller 2002 through wiring patterns 2005 provided in the main board 2001.

The main board 2001 may include a connector 2006 including a plurality of pins that are provided to have connection with an external host. The number and arrangement of the plurality of pins on the connector 2006 may be changed based on a communication interface between the electronic system 2000 and an external host. The electronic system 2000 may communicate with an external host through one of interfaces, for example, universal serial bus (USB), peripheral component interconnect express (PIC-Express), serial advanced technology attachment (SATA), and M-PHY for universal flash storage (UFS). For example, the electronic system 2000 may operate with power supplied through the connector 2006 from an external host. The electronic system 2000 may further include a power management integrated circuit (PMIC) that distributes the power supplied from an external host to the controller 2002 and the semiconductor package 2003.

The controller 2002 may write data to the semiconductor package 2003, may read data from the semiconductor package 2003, or may increase an operating speed of the electronic system 2000.

The DRAM 2004 may be a buffer memory that reduces a difference in speed between an external host and the semiconductor package 2003 that serves as a data storage space. The DRAM 2004 included in the electronic system 2000 may operate as a kind of cache memory, and may provide a space for temporary data storage in a control operation of the semiconductor package 2003. When the DRAM 2004 is included in the electronic system 2000, the controller 2002 may include not only a NAND controller for controlling the semiconductor package 2003, but also a DRAM controller for controlling the DRAM 2004.

The semiconductor package 2003 may include first and second semiconductor packages 2003a and 2003b that are spaced apart from each other. Each of the first and second semiconductor packages 2003a and 2003b may include a plurality of semiconductor chips 2200. Each of the first and second semiconductor packages 2003a and 2003b may include a package substrate 2100, semiconductor chips 2200 on the package substrate 2100, adhesion layers 2300 on bottom surfaces of the semiconductor chips 2200, connection structures 2400 that electrically connect the semiconductor chips 2200 to the package substrate 2100, and a molding layer 2500 that lies on the package substrate 2100 and covers the semiconductor chips 2200 and the connection structures 2400

The package substrate 2100 may be an integrated circuit board including package upper pads 2130. Each of the semiconductor chips 2200 may include input/output pads 2210. Each of the input/output pads 2210 may correspond to the input/output pad 1101 of FIG. 1. Each of the semiconductor chips 2200 may include gate stack structures 3210 and memory channel structures 3220. Each of the semiconductor chips 2200 may include a three-dimensional semiconductor memory device which will be discussed below.

The connection structures 2400 may be, for example, bonding wires that electrically connect the input/output pads 2210 to the package upper pads 2130. Therefore, on each of the first and second semiconductor packages 2003a and 2003b, the semiconductor chips 2200 may be electrically connected to each other in a wire bonding manner, and may be electrically connected to the package upper pads 2130 of the package substrate 2100. In some embodiments, on each of the first and second semiconductor packages 2003a and 2003b, the semiconductor chips 2200 may be electrically connected to each other using through-silicon vias instead of the connection structures 2400 or the bonding wires.

Differently from that shown, the controller 2002 and the semiconductor chips 2200 may be included in a single package. The controller 2002 and the semiconductor chips 2200 may be mounted on a separate interposer substrate other than the main board 2001, and may be connected to each other through connection lines provided in the interposer substrate.

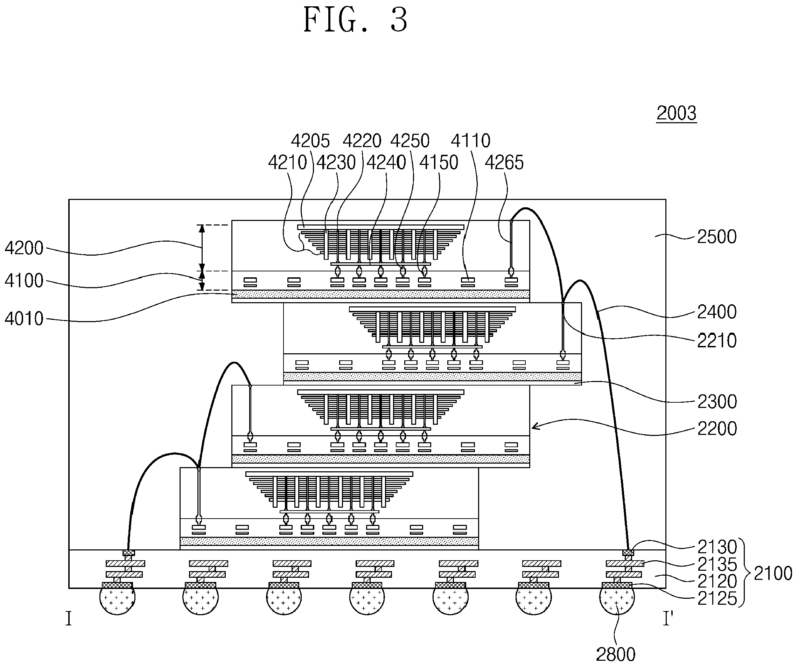

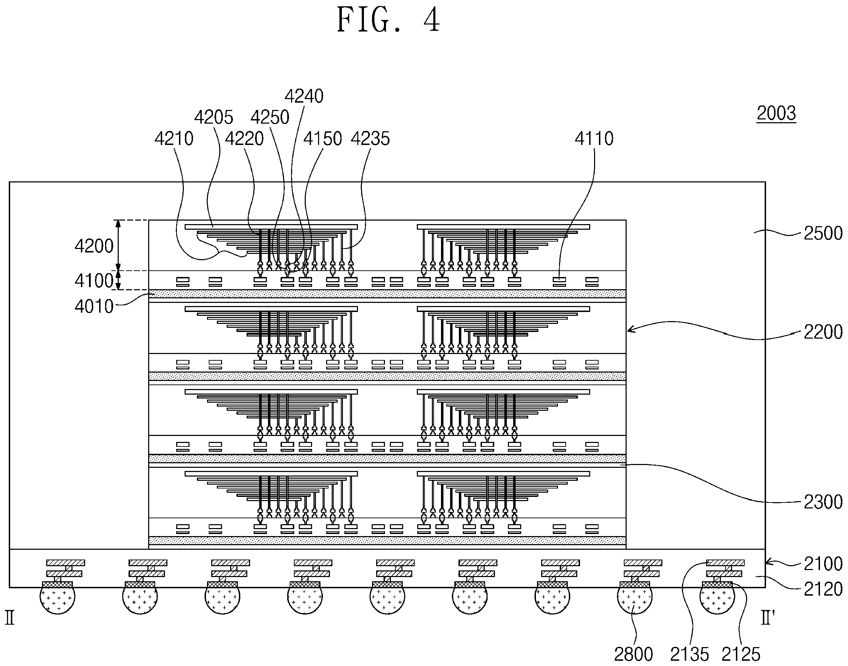

FIGS. 3 and 4 are cross-sectional views respectively taken along lines I-I' and II-II' of FIG. 2 according to some embodiments of the present inventive concepts.

Referring to FIGS. 3 and 4, a semiconductor package 2003 may include a package substrate 2100, a plurality of semiconductor chips 2200 on the package substrate 2100, and a molding layer 2500 that covers the package substrate 2100 and the semiconductor chips 2200.

The package substrate 2100 may include a package substrate body 2120, upper pads 2130 disposed or exposed on a top surface of the package substrate body 2120, lower pads 2125 disposed or exposed on a bottom surface of the package substrate body 2120, and internal lines 2135 that lie in the package substrate body 2120 and electrically connect the upper pads 2130 to the lower pads 2125. The package upper pads 2130 may be electrically connected to connection structures 2400. The lower pads 2125 may be connected through conductive connectors 2800 to the wiring patterns 2005 in the main board 2001 of the electronic system 2001 depicted in FIG. 2.

Referring to FIGS. 2 and 3, the semiconductor chips 2200 may have sidewalls that are not aligned with each other and also include other sidewalls that are aligned with each other. The semiconductor chips 2200 may be electrically connected to each other thorough the connection structures 2400 shaped like bonding wires. The semiconductor chips 2200 may be configured substantially identical to each other.

Each of the semiconductor chips 2200 may include a semiconductor substrate 4010, a first structure 4100 on the semiconductor substrate 4010, and a second structure 4200 on the first structure 4100. The second structure 4200 and the first structure 4100 may be bonded to each other in a wafer bonding manner.

The first structure 4100 may include peripheral circuit lines 4110 and first bonding pads 4150. The second structure 4200 may include a common source line 4205, a gate stack structure 4210 between the common source line 4205 and the first structure 4100, memory channel structures 4220 and separation structures 4230 that penetrate the gate stack structure 4210, and second bonding pads 4250 that are correspondingly or respectively electrically connected to the memory channel structures 4220 and the word lines (see WL of FIG. 1) of the gate stack structure 4210.

For example, the second bonding pads 4250 may be electrically connected to the memory channel structures 4220 and the word lines (see WL of FIG. 1) through bit lines 4240 electrically connected to the memory channel structures 4220 and through gate connection lines 4235 electrically connected to the word lines (see WL of FIG. 1). The first bonding pads 4150 of the first structure 4100 may be bonded to and in contact with the second bonding pads 4250 of the second structure 4200. The first and second bonding pads 4150 and 4250 may have their contact portions including, for example, copper (Cu).

Each of the semiconductor chips 2200 may further include input/output pads 2210 and input/output connection lines 4265 below the input/output pads 2210. The input/output connection line 4265 may be electrically connected to one of the second bonding pads 4250 and one of the peripheral circuit lines 4110.

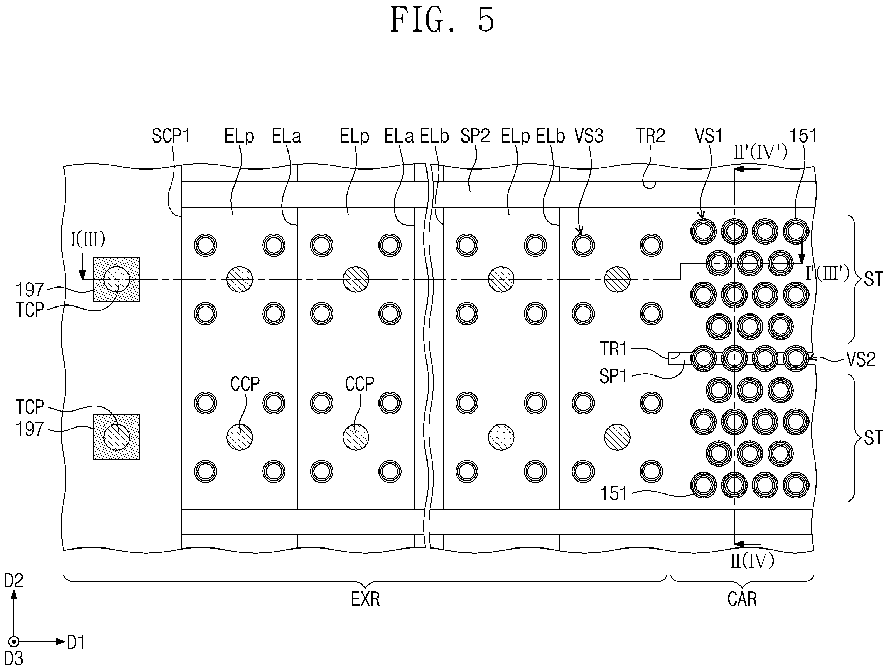

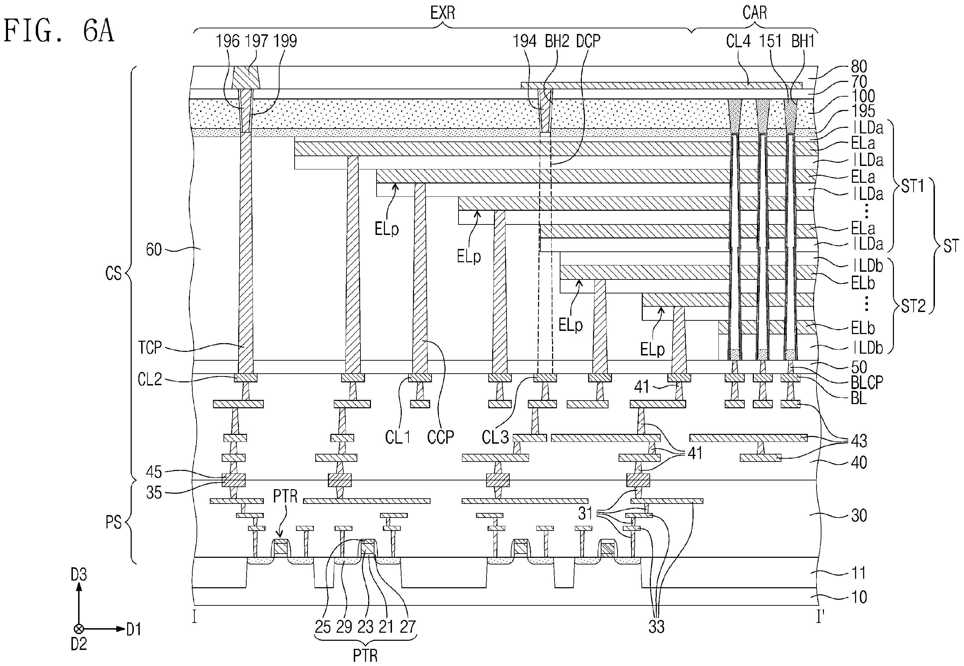

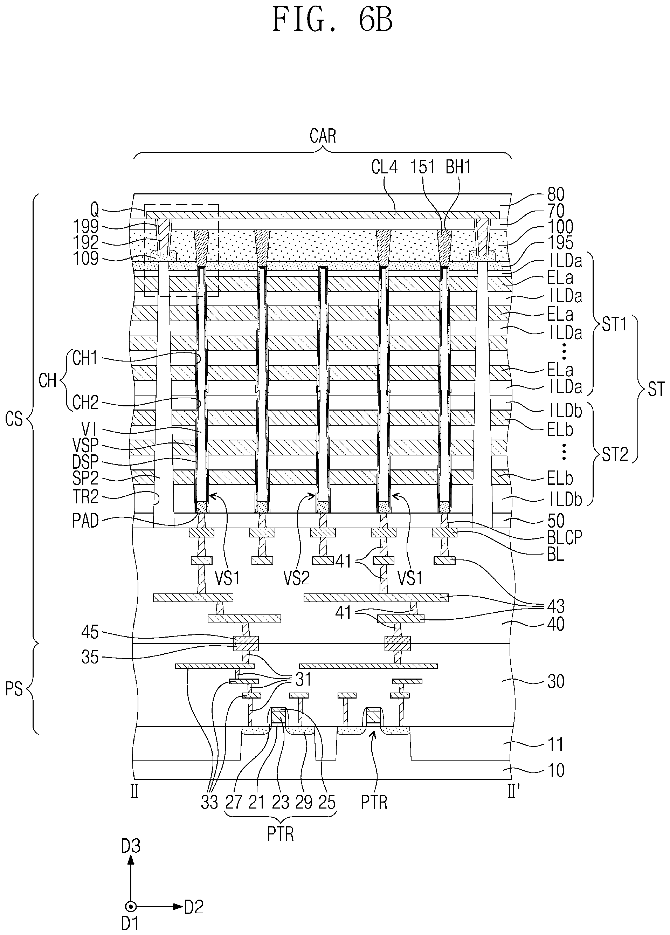

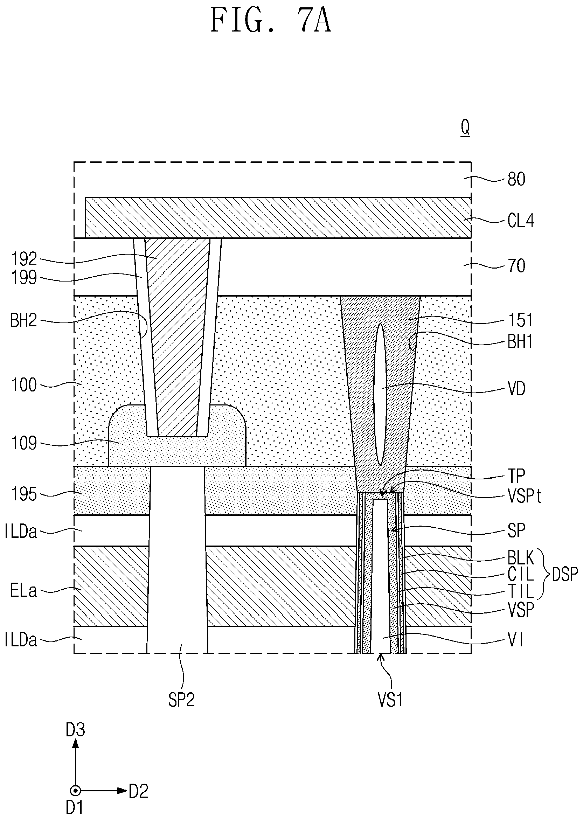

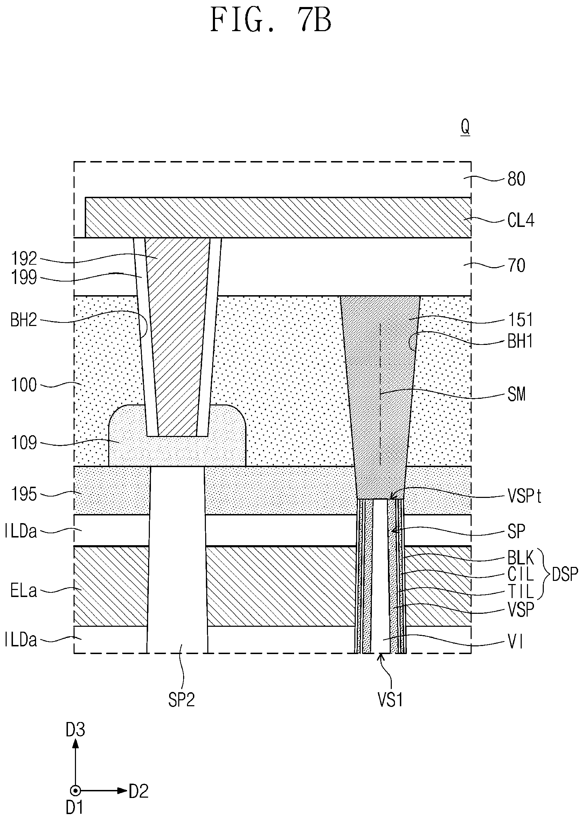

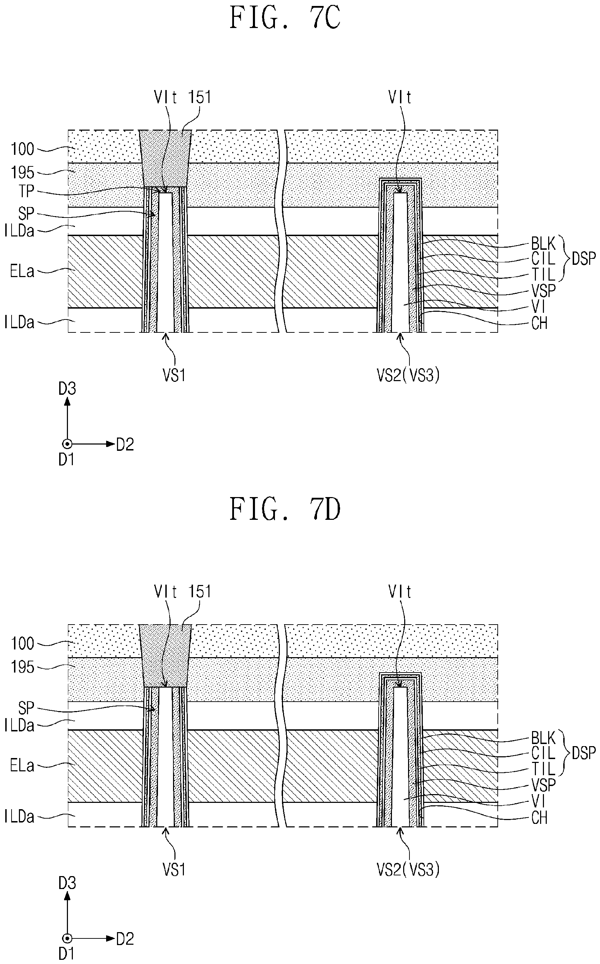

FIG. 5 is a plan view of a three-dimensional semiconductor memory device according to some embodiments of the present inventive concepts. FIGS. 6A and 6B are cross-sectional views respectively taken along lines I-I' and II-II' of FIG. 5 according to some embodiments of the present inventive concepts. FIGS. 7A and 7B are enlarged views showing section Q of FIG. 6 according to some embodiments of the present inventive concepts. FIGS. 7C and 7D illustrate cross-sectional views showing a structural difference between vertical channel structures which will be discussed below.

Referring to FIGS. 5, 6A, and 6B, a three-dimensional semiconductor memory device according to some embodiments of the present inventive concepts may include a first substrate 10, a peripheral circuit structure PS on the first substrate 10, and a cell array structure CS on the peripheral circuit structure PS. The first substrate 10, the peripheral circuit structure PS, and the cell array structure CS may respectively correspond to the semiconductor substrate 4010, the first structure 4100 on the semiconductor substrate 4010, and the second structure 4200 on the first structure 4100 of FIG. 3 or 4.

As the cell array structure CS is bonded onto the peripheral circuit structure PS, it may be possible to increase a cell capacity per unit area of a three-dimensional semiconductor memory device according to some embodiments of the present inventive concepts. In addition, as the peripheral circuit structure PS and the cell array structure CS are manufactured separately and then bonded to each other, subsequently described peripheral transistors PTR may not be damaged by various heat treatment processes, and accordingly, it may be possible to improve reliability and electrical properties of the three-dimensional semiconductor memory device according to some embodiments of the present inventive concepts.

The first substrate 10 may be, for example, a silicon substrate, a silicon-germanium substrate, a germanium substrate, or a monocrystalline epitaxial layer grown on a monocrystalline silicon substrate. The first substrate 10 may have a first conductivity type. For example, the first conductivity type may be a p-type. The first substrate 10 may have a top surface that is parallel to a first direction D1 and a second direction D2 that intersects the first direction D1 and is perpendicular to a third direction D3. The first, second, and third directions D1, D2, and D3 may be directions orthogonal to each other. A device isolation layer 11 may be provided in the first substrate 10. The device isolation layer 11 may define an active region of the first substrate 10.

The first substrate 10 may be provided thereon with the peripheral circuit structure PS including peripheral transistors PTR on the first substrate 10, peripheral contact plugs 31, peripheral circuit lines 33 electrically connected through the peripheral contact plugs 31 to the peripheral transistors PTR, first bonding pads 35 electrically connected to the peripheral circuit lines 33, and a first interlayer dielectric layer 30 that surrounds the peripheral transistors PTR, the peripheral circuit lines 33, and the first bonding pads 35. The peripheral transistors PTR may be disposed on the active region of the first substrate 10. The peripheral circuit lines 33 may correspond to the peripheral circuit lines 4110 of FIG. 3 or 4, and the first bonding pads 35 may correspond to the first bonding pads 4150 of FIG. 3 or 4.

The peripheral contact plugs 31 may each have a width in the first direction D1 or the second direction D2, and for example, the width may increase in the third direction D3. The peripheral circuit plugs 31 and the peripheral circuit lines 33 may include a conductive material, such as metal.

The peripheral transistors PTR may include, for example, a decoder circuit (e.g., 1110 of FIG. 1), a page buffer (e.g., 1120 of FIG. 1), and a logic circuit (e.g., 1130 of FIG. 1). For example, each of the peripheral transistors PTR may include a peripheral gate dielectric layer 21, a peripheral gate electrode 23, a peripheral capping pattern 25, a peripheral gate spacer 27, and peripheral source/drain regions 29.

The peripheral gate dielectric layer 21 may be provided between the peripheral gate electrode 23 and the first substrate 10. The peripheral capping pattern 25 may be provided on the peripheral gate electrode 23. The peripheral gate spacer 27 may cover a sidewall of each of the peripheral gate dielectric layer 21, the peripheral gate electrode 23, and the peripheral capping pattern 25. The peripheral source/drain regions 29 may be provided in the first substrate 10 adjacent to opposite sides of the peripheral gate electrode 23.

The peripheral circuit lines 33 and the first bonding pads 35 may be electrically connected through the peripheral contact plugs 31 to the peripheral transistors PTR. Each of the peripheral transistors PTR may be, for example, an NMOS transistor or a PMOS transistor.

The first interlayer dielectric layer 30 may be provided on the first substrate 1. On the first substrate 10, the first interlayer dielectric layer 30 may cover the peripheral transistors PTR, the peripheral contact plugs 31, and the peripheral circuit lines 33. The first interlayer dielectric layer 30 may include a plurality of dielectric layers having a multi-layered structure. For example, the first interlayer dielectric layer 30 may include silicon oxide, silicon nitride, silicon oxynitride, and/or low-k dielectrics. The first interlayer dielectric layer 30 may not cover top surfaces of the first bonding pads 35. A top surface of the first interlayer dielectric layer 30 may be substantially coplanar with those of the first bonding pads 35.

The peripheral circuit structure PS may be provided thereon with the cell array structure CS including second bonding pads 45, bit lines BL, a stack structure ST, and a second substrate 100. The cell array structure CS may include a cell array area CAR and a cell array contact area EXR. The cell array contact area EXR may extend from the cell array area CAR in the first direction D1 or in a direction opposite to the first direction D1.

The second bonding pads 45, the bit lines BL, and the stack structure ST may respectively correspond to the second bonding pads 4250, the bit lines 4240, and the gate stack structure 4210 of FIG. 3 or 4. The first interlayer dielectric layer 30 may be provided thereon with second bonding pads 45 in contact with the first bonding pads 35 of the peripheral circuit structure PS, connection contact plugs 41, connection circuit lines 43 electrically connected through the connection contact plugs 41 to the second bonding pads 45, and a second interlayer dielectric layer 40 that surrounds the second bonding pads 45, the connection contact plugs 41, and the connection circuit lines 43.

The second interlayer dielectric layer 40 may include a plurality of dielectric layers having a multi-layered structure. For example, the second interlayer dielectric layer 40 may include silicon oxide, silicon nitride, silicon oxynitride, and/or low-k dielectrics.

For example, the connection contact plugs 41 may each have a width in the first direction D1 or the second direction D2 that decreases in the third direction D3. The connection contact plugs 41 and the connection circuit lines 43 may include a conductive material, such as metal.

The second interlayer dielectric layer 40 may not cover bottom surfaces of the second bonding pads 45. A bottom surface of the second interlayer dielectric layer 40 may be substantially coplanar with those of the second bonding pads 45. The bottom surfaces of the second bonding pads 45 may be correspondingly in direct contact with the top surfaces of the first bonding pads 35. The first and second bonding pads 35 and 45 may include metal, such as copper (Cu), tungsten (W), aluminum (Al), nickel (Ni), or tin (Sn). For example, the first and second bonding pads 35 and 45 may include copper (Cu).

In some embodiments, the first and second bonding pads 35 and 45 may have a single unitary structure without any interface (e.g., a visible interface) therebetween. Although the first and second bonding pads 35 and 45 are illustrated to have their sidewalls aligned with each other, the present inventive concepts are not limited thereto, and when viewed in plan, the first and second bonding pads 35 and 45 may have their sidewalls spaced apart from each other.

The second interlayer dielectric layer 40 may be provided in its upper portion with the bit lines BL and first, second, and third conductive lines CL1, CL2, and CL3. In some embodiments, those lines BL, CL1, CL2, and CL3 may be in contact with the connection contact plugs 41. For example, the bit lines BL and the first, second, and third conductive lines CL1, CL2, and CL3 may each extend in the second direction D2 and may be spaced apart from each other in the first direction D1. The bit lines BL and the first, second, and third conductive lines CL1, CL2, and CL3 may include a conductive material, such as metal.

A third interlayer dielectric layer 50 may be provided on the second interlayer dielectric layer 40. The third interlayer dielectric layer 50 may be provided thereon with a fourth interlayer dielectric layer 60 and the stack structure ST that is surrounded by the fourth interlayer dielectric layer 60. The third and fourth dielectric layers 50 and 6 may each include a plurality of dielectric layers having a multi-layered structure. For example, the third and fourth interlayer dielectric layers 50 and 60 may include silicon oxide, silicon nitride, and/or silicon oxynitride.

The third interlayer dielectric layer 50 may be provided with bit-line contact plugs BLCP therein. The bit-line contact plugs BLCP may extend in the third direction D3, and may connect the bit lines BL to first vertical channel structures VS1 which will be discussed below.

Cell contact plugs CCP, a source contact plug DCP, and a through contact plug TCP may be provided to penetrate the third interlayer dielectric layer 50 and the fourth interlayer dielectric layer 60. The cell contact plugs CCP may extend in the third direction D3, and may connect the first conductive lines CL1 to subsequently described conductive patterns ELa and ELb of the stack structure ST. Each of the cell contact plugs CCP may penetrate one of subsequently described interlayer dielectric layers ILDa and ILDb of the stack structure ST. The through contact plug TCP may extend in the third direction D3, and may connect the second conductive line CL2 to a backside conductive pattern 197 which will be discussed below. The source contact plug DCP may extend in the third direction D3, and may connect the third conductive line CL3 to a second source via 194 which will be discussed below. As used herein "an element A penetrates an element B" (or similar language) may mean that at least a portion of the element A extends into the element B such that the at least a portion of the element A is in the element B.

The bit-line contact plugs BLCP, the cell contact plugs CCP, and the through contact plug TCP may be spaced apart from each other in the first direction D1. The bit-line contact plugs BLCP, the cell contact plugs CCP, the source contact plug DCP, and the through contact plug TCP may have their widths in the first direction D1 and/or the second direction D2 that decrease in the third direction D3. The bit-line contact plugs BLCP, the cell contact plugs CCP, the source contact plug DCP, and the through contact plug TCP may include a metallic material, such as tungsten.

The stack structure ST may be provided on the third interlayer dielectric layer 50. The stack structure ST may be surrounded by the fourth interlayer dielectric layer 60. The stack structure ST may have a bottom surface (or one surface in contact with the third interlayer dielectric layer 50) substantially coplanar with that of the fourth interlayer dielectric layer 60.

The stack structure ST may be provided in plural. When viewed in plan as shown in FIG. 5, the plurality of stack structures ST may extend in the first direction D1 and may be spaced apart from each other in the second direction D2. For convenience of discussion, the following will focus on a single stack structure ST, and a description below may be identically applicable to other stack structures ST.

The stack structure ST may include interlayer dielectric layers and conductive patterns that are stacked alternately with interlayer dielectric layers. The stack structure ST may have an inverted stepwise shape formed of interlayer dielectric layers and conductive patterns. For example, the stack structure ST may include a first stack structure ST1 and a second stack structure ST2. The first stack structure ST1 may include first interlayer dielectric layers ILDa and first conductive patterns ELa that are alternately stacked, and the second stack structure ST2 may include second interlayer dielectric layers ILDb and second conductive patterns ELb that are alternately stacked.

The second stack structure ST2 may be provided between the first stack structure ST1 and the first substrate 10. For example, the second stack structure ST2 may be provided on a bottom surface of a bottommost one of the first interlayer dielectric layers ILDa included in the first stack structure ST1. Although FIGS. 6A and 6B illustrate that a topmost one of the second interlayer dielectric layers ILDb included in the second stack structure ST2 is in contact with the bottommost one of the first interlayer dielectric layers ILDa included in the first stack structure ST1, the present inventive concepts are not limited thereto, and a single-layered dielectric layer may be provided between a topmost one of the second conductive patterns ELb included in the second stack structure ST2 and a bottommost one of the first conductive patterns ELa included in the first stack structure ST1.

The second substrate 100 may be provided on the stack structure ST. An etch stop layer 195 may be provided between the stack structure ST and the second substrate 100. The second substrate 100 may include a monocrystalline semiconductor layer. The second substrate 100 may be, for example, a silicon substrate, a silicon-germanium substrate, a germanium substrate, or a monocrystalline epitaxial layer grown on a monocrystalline silicon substrate. The second substrate 100 may have a first conductivity type. For example, the first conductivity type may be a p-type.

The etch stop layer 195 may include a material having an etch selectivity with respect to a silicon oxide layer and a silicon nitride layer. For example, the etch stop layer 195 may be a high-k dielectric metal oxide layer. The etch stop layer 195 may include, for example, one of an aluminum oxide layer, a titanium oxide layer, and a tantalum oxide layer. The second substrate 100 may have a thickness of about 1 µm to about 3 µm.

The first and second conductive patterns ELa and ELb may be formed of the same material at the same time (e.g., through the same processes). The first and second conductive patterns ELa and ELb may include, for example, at least one selected from doped semiconductors (e.g., doped silicon), metals (e.g., tungsten, molybdenum, nickel, copper, or aluminum), conductive metal nitrides (e.g., titanium nitride or tantalum nitride), and transition metals (e.g., titanium or tantalum). The first and second interlayer dielectric layers ILDa and ILDb may include silicon oxide, silicon nitride, silicon oxynitride, and/or low-k dielectrics. For example, the first and second interlayer dielectric layers ILDa and ILDb may include high-density plasma (HDP) oxide or tetraethylorthosilicate (TEOS).

On the cell array contact area EXR, each of the first and second stack structures ST1 and ST2 may have a thickness in the third direction D3 that decreases with increasing distance from an outermost one of first vertical channel structures VS1 which will be discussed below. For example, each of the first and second stack structures ST1 and ST2 may have an inverted stepwise structure along the first direction D1.

The first and second conductive patterns ELa and ELb may have their lengths in the first direction D1 that increase with increasing distance from the first substrate 10. When viewed in plan as shown in FIG. 5, the first and second conductive patterns ELa and ELb may have their sidewalls that are spaced apart from each other at a regular interval along the first direction D1. A bottommost one of the second conductive patterns ELb included in the second stack structure ST2 may have a shortest length (e.g., a minimum length) in the first direction D1 among the second conductive patterns ELb, and a topmost one of the second conductive patterns ELb included in the second stack structure ST2 may have a longest length (e.g., a maximum length) in the first direction D1 among the second conductive patterns ELb.

The first and second conductive patterns ELa and ELb may have their pad parts ELp on the cell array contact area EXR. The pad parts ELp may be disposed at positions that are horizontally and vertically different from each other. The pad parts ELp may constitute a stepwise structure along the first direction D1. The cell contact plugs CCP may penetrate one of the first and second interlayer dielectric layers ILDa and ILDb to come into contact with the pad parts ELp of the first and second conductive patterns ELa and ELb. In some embodiments, as illustrated in FIG. 6A, the source contact plug DCP may penetrate the stack structure ST to be inserted into the etch stop layer 195. The source contact plug DCP may be electrically separated (e.g., electrically insulated) from the first and second conductive patterns ELa and ELb.

In some embodiments, the source contact plug DCP may be provided to penetrate portions, which remain on the cell array contact area EXR, of first and second interlayer dielectric layers 111 and 112 and first and second sacrificial layers 121 and 122 that are alternately stacked as discussed below. In some other embodiments, the source contact plug DCP may be spaced apart from the first and second conductive patterns ELa and ELb across a dielectric spacer that covers a sidewall of a through hole that penetrates the stack structure ST.

The first and second interlayer dielectric layers ILDa and ILDb may be provided between the first and second conductive patterns ELa and ELb, and may each have a sidewall aligned with that of an overlaying one of the first and second conductive patterns ELa and ELb. The first and second interlayer dielectric layers ILDa and ILDb may have their lengths in the first direction D1 that increase with increasing distance from the first substrate 10. A bottommost one of the second interlayer dielectric layers ILDb may have a thickness in the third direction D3 greater than a thickness of any other of the second interlayer dielectric layers ILDb, and a topmost one of the first interlayer dielectric layers ILDa may have a thickness in the third direction D3 less than a thickness of any other of the first interlayer dielectric layers ILDa, but the present inventive concepts are not limited thereto.

On the cell array area CAR, first vertical channel structures VS 1 and second vertical channel structures VS2 may be provided in vertical channel holes CH that penetrate and extend in the third direction D3 through the stack structure ST. The first vertical channel structures VS1 may correspond to the memory channel structures 4220 of FIG. 3 or 4.

On the cell array contact area EXR, third vertical channel structures VS3 may be provided in vertical channel holes CH that penetrate and extend in the third direction D3 through the fourth interlayer dielectric layer 60 and at least a portion of the stack structure ST. As shown in FIG. 5, a plurality of third vertical channel structures VS3 may be formed around the source contact plug DCP or each of the cell contact plugs CCP. The second vertical channel structures VS2 and the third vertical channel structures VS3 may be dummy structures that do not operate as memory cells.

The vertical channel holes CH may include first vertical channel holes CH1 and second vertical channel holes CH2 that are spatially connected to the first vertical channel holes CH1, respectively. Each of the first and second vertical channel holes CH1 and CH2 may have a width in the first direction D1 or the second direction D2 that decreases with increasing distance from the first substrate 10. The first and second vertical channel holes CH1 and CH2 may have their diameters that are different from each other at a boundary where the first and second vertical channel holes CH1 and CH2 are spatially connected to each other. For example, each of the second vertical channel holes CH2 may have at its upper portion a diameter less than that at a lower portion of each of the first vertical channel holes CH1.

The first and second vertical channel holes CH1 and CH2 may have a step difference at a boundary thereof. The present inventive concepts, however, are not limited thereto, and differently from that shown, first, second, and third vertical channel structures VS1, VS2, and VS3 may be provided in three or more vertical channel holes CH having a step difference at each of two or more boundaries therebetween, and first, second, and third vertical channel structures VS1, VS2, and VS3 may be provided in vertical channel holes CH having a flat sidewall without any step difference.

As shown in FIGS. 6B, 7A, and 7B, each of the first, second, and third vertical channel structures VS1, VS2, and VS3 may include a conductive pad PAD adjacent to the third interlayer dielectric layer 50, a data storage pattern DSP that conformally covers an inner wall of each of the first and second vertical channel holes CH1 and CH2, a vertical semiconductor pattern VSP that conformally covers a sidewall of the data storage pattern DSP, and a buried dielectric pattern VI that fills an inner space of each of the first and second vertical channel holes CH1 and CH2, which inner space is surrounded by the vertical semiconductor pattern VSP and the conductive pad PAD. The vertical semiconductor pattern VSP may be surrounded by the data storage pattern DSP. Each of the first, second, and third vertical channel structures VS1, VS2, and VS3 may have, for example, a circular shape, an oval shape, or a bar shape on a bottom surface thereof.

The vertical semiconductor pattern VSP may be provided between the data storage pattern DSP and the buried dielectric pattern VI and between the data storage pattern DSP and the conductive pad PAD. The vertical semiconductor pattern VSP may include, for example, an impurity-doped semiconductor material, an impurity-undoped intrinsic semiconductor material, or a polycrystalline semiconductor material. The conductive pad PAD may include, for example, an impurity-doped semiconductor material or a conductive material.

When viewed in plan as shown in FIG. 5, a first trench TR1 and a second trench TR2 may be provided to extend in the first direction D1 and to run across the stack structure ST. The first trench TR1 may be provided on the cell array area CAR, and the second trench TR2 may extend from the cell array area CAR toward the cell array contact area EXR. The first and second trenches TR1 and TR2 may have their widths in the first direction D1 or the second direction D2 that decrease with increasing distance from the first substrate 10.

A first separation pattern SP1 and a second separation pattern SP2 may be provided to respectively fill the first trench TR1 and the second trench TR2. The first and second separation patterns SP1 and SP2 may correspond to the separation structures 4230 of FIG. 3 or 4. The second separation pattern SP2 may have a length in the first direction D1 greater than a length in the first direction D1 of the first separation pattern SP1. The first and second separation patterns SP1 and SP2 may have their sidewalls in contact with at least portions of the first and second conductive patterns ELa and ELb and the first and second interlayer dielectric layers ILDa and ILDb included in the stack structure ST. The first and second separation patterns SP1 and SP2 may include, for example, oxide, such as silicon oxide.

A bottom surface of the second separation pattern SP2 may be substantially coplanar with a bottom surface of the third interlayer dielectric layer 50 (or a top surface of the second interlayer dielectric layer 40) and top surfaces of the bit lines BL and the first, second, and third conductive lines CL1, CL2, and CL3. The second separation pattern SP2 may have a top surface located at a higher level than those of top surfaces of the first, second, and third vertical channel structures VS1, VS2, and VS3. For example, the second separation pattern SP2 may penetrate the etch stop layer 195. As used herein, "a surface V is at a higher level than a surface W" (or similar language) means that the surface W is closer than the surface V to a substrate, and the surface W is lower than the surface V relative to the first substrate 10.

When the stack structure ST is provided in plural, one of the first and second separation patterns SP1 and SP2 may be provided between the stack structures ST that are arranged along the second direction D2. For example, the stack structures ST may be spaced apart in the second direction D2 from each other across the first separation pattern SP1 or the second separation pattern SP2.

The data storage pattern DSP may include a blocking dielectric layer BLK, a charge storage layer CIL, and a tunneling dielectric layer TIL that are sequentially stacked on a sidewall of the vertical channel hole CH. The blocking dielectric layer BLK may be adjacent to the stack structure ST, and the tunneling dielectric layer TIL may be adjacent to the vertical semiconductor pattern VSP. The charge storage layer CIL may be interposed between the blocking dielectric layer BLK and the tunneling dielectric layer TIL. The blocking dielectric layer BLK, the charge storage layer CIL, and the tunneling dielectric layer TIL may extend in the third direction D3 between the stack structure ST and the vertical semiconductor pattern VSP. The data storage pattern DSP may store and/or change data by using Fowler-Nordheim tunneling induced by a voltage difference between the vertical semiconductor pattern VSP and the first and second conductive patterns ELa and ELb. For example, the blocking dielectric layer BLK and the tunneling dielectric layer TIL may include silicon oxide, and the charge storage layer CIL may include silicon nitride or silicon oxynitride.

With reference to FIGS. 7A to 7D, the following will describe in detail connection vias 151 and their adjacent structure.

The first vertical channel structures VS1 may be correspondingly and respectively provided thereon with connection vias 151 that penetrate the second substrate 100. In some embodiments, the connection vias 151 may not be provided on the second vertical channel structures VS2 or the third vertical channel structures VS3. The connection vias 151 may penetrate the second substrate 100 to come into connection with top surfaces of the vertical semiconductor patterns VSP included in the first vertical channel structures VS1. The connection vias 151 may include, for example, a semiconductor material, such as silicon or germanium. For example, the connection vias 151 may include a polycrystalline silicon layer having a first conductivity type. For example, the first conductivity type may be a p-type. The first vertical channel structures VS1 may be electrically connected through the connection vias 151 to the second substrate 100. In the etch stop layer 195, the connection vias 151 may be connected to the first vertical channel structures VS1, but the present inventive concepts are not limited thereto. In some embodiments, the connection vias 151 may overlap the first vertical channel structures VS1 in the third direction D3, respectively, and may not overlap the second vertical channel structures VS2 or the third vertical channel structures VS3, as illustrated in FIGS. 6A, 6B, and 7A through 7D. As used herein, "an element A overlapping an element B in a direction X" (or similar language) means that there is at least one line that extends in the direction X and intersects both the elements A and B.

The connection vias 151 may have a width at their upper portion greater than a width at their lower portion. The connection vias 151 may be provided in first via holes BH1. at least one of the connection vias 151 may be provided therein with a void VD as shown in FIG. 7A. The void VD may indicate a region either filled with a gas or not filled with a solid such as vacuum. In some embodiments, as illustrated in FIG. 7B, the connection vias 151 may include a seam SM or an interface between portions that are grown or deposited in contact with each other in a fabrication method which will be discussed below. As used herein, "a lower portion" of an element refers to a portion that is closer than "an upper portion" thereof to the first substrate 10.

In some embodiments, as illustrated in FIGS. 7A and 7C, the vertical semiconductor pattern VSP of the first vertical channel structure VS1 may include a first part SP that covers a sidewall of the vertical channel hole CH and a second part TP that covers a top surface VIt of the buried dielectric pattern VI. For example, the vertical semiconductor pattern VSP may have a pipe shape whose top end is closed, and an upper portion of the buried dielectric pattern VI may be surrounded by the first part SP and the second part TP of the vertical semiconductor pattern VSP. A bottom surface of the connection via 151 may be connected to a top surface of the second part TP included in the vertical semiconductor pattern VSP. In addition, the bottom surface of the connection via 151 may be connected to a top surface of the data storage pattern DSP. The data storage pattern DSP may have a pipe shape whose upper portion is opened.

In some embodiments, as illustrated in FIGS. 7B and 7D, the vertical semiconductor pattern VSP of the first vertical channel structure VS1 may not include the second part TP. For example, the vertical semiconductor pattern VSP may have a pipe shape whose upper portion is opened. The connection via 151 may have a bottom surface that is connected in common to (e.g., contact) a top surface of the first part SP included in the vertical semiconductor pattern VSP, a top surface of the data storage pattern DSP, and a top surface of the buried dielectric pattern VI.

Referring to FIGS. 7C and 7D, there is a detailed illustration of a connection relationship between the connection via 151 and the first, second, and third vertical channel structures VS1, VS2, and VS3. The first vertical channel structure VS1 may be provided thereon with the connection via 151 that is connected to the vertical semiconductor pattern VSP as illustrated in the form shown in FIG. 7A or 7B. In some embodiments, the second vertical channel structure VS2 and the third vertical channel structure VS3 may each have an upper portion whose structure is different from that of the first vertical channel structure VS1. The second and third vertical channel structures VS2 and VS3 may be configured such that each of the data storage pattern DSP and the vertical semiconductor pattern VSP may have a pipe shape whose upper portion is closed. For example, the vertical semiconductor pattern VSP may cover the top surface VIt of the buried dielectric pattern VI, and the data storage pattern DSP may cover the top surface of the vertical semiconductor pattern VSP. The vertical semiconductor pattern VSP may be electrically separated (e.g., electrically insulated) through the data storage pattern DSP from the second substrate 100. In some embodiments, an interface between the connection via 151 and one of vertical channel structures (e.g., the first, second, and third vertical channel structures VS1, VS2, and VS3) is in the etch stop layer 195, as illustrated in FIGS. 7A through 7D.

The second substrate 100 may be provided therein with a common source region 109 having a second conductivity type. The second conductivity type may be an n-type. For example, a concentration of n-type impurities in the common source region 109 may range from about 2×10¹⁵/cm³ to about 9×10¹⁵/cm³. The common source region 109 may be adjacent to a lower portion of the second substrate 100 or to the stack structure ST. The common source region 109 may extend in the first direction D1 along the second separation pattern SP2. For example, a planar shape of the common source region 109 may be the same as or overlap with that of the second separation pattern SP2.

A first source via 192 may be provided to be connected to the common source region 109, a second source via 194 may be provided to be connected to the source contact plug DCP, and a through via 196 may be provided to be connected to the through contact plug TCP. The first source via 192, the second source via 194, and the through via 196 may be electrically separated (e.g., electrically insulated) from the second substrate 100 across a dielectric spacer pattern 199. The first source via 192, the second source via 194, and the through via 196 may be provided in second via holes BH2.

A fifth interlayer dielectric layer 70 and a sixth interlayer dielectric layer 80 may be sequentially provided on the second substrate 100. For example, the fifth interlayer dielectric layer 70 and the sixth interlayer dielectric layer 80 may be a silicon oxide layer. The first source via 192, the second source via 194, and the through via 196 may penetrate the fifth interlayer dielectric layer 70. In some embodiments, the first source via 192, the second source via 194, and the through via 196 may include the same material. For example, the first source via 192, the second source via 194, and the through via 196 may include at least one selected from tungsten, titanium, and tantalum.

A common source line CL4 may be provided to connect the first source via 192 and the second source via 194 to each other. The common source line CL4 may be provided in the sixth interlayer dielectric layer 80. The vertical semiconductor patterns VSP of the first vertical channel structures VS1 may be electrically connected through the connection vias 151 to the second substrate 100, and may also be electrically connected to the common source region 109. The common source region 109 may be electrically connected to the peripheral transistors PTR through first and second source vias 192 and 194 and the source contact plug DCP, and the common source line CL4. Therefore, memory cells may use the second substrate 100 and the common source region 109 to perform a bulk erase operation without removing data by using a gate induced drain leakage (GIDL) phenomenon caused by erase control transistors.

A backside conductive pattern 197 may be provided in the sixth interlayer dielectric layer 80 and connected to the through via 196. In some embodiments, the backside conductive pattern 197 may have a width at its bottom surface less than a width at its top surface, as illustrated in FIG. 6A. The backside conductive pattern 197 may be electrically connected to the second conductive line CL2 through the through via 196 and the through contact plug TCP, and may also be electrically connected to at least one of the peripheral transistors PTR included in the peripheral circuit structure PS. The backside conductive pattern 197 may correspond to the input/output pad 1101 shown in FIG. 1 or one of the input/output pads 2210 depicted in FIG. 4. In some embodiments, the backside conductive pattern 197 may be a portion of backside metal lines. The backside conductive pattern 197 may include a different material from that of the through via 196 and that of the through contact plug TCP. For example, the backside conductive pattern 197 may include aluminum, and the through via 196 and the through contact plug TCP may include at least one selected from tungsten, titanium, and tantalum.

According to some embodiments of the present inventive concepts, a bulk erase operation may be possibly performed by the second substrate 100 and the connection vias 151 connected to the vertical semiconductor patterns VSP of the first vertical channel structures VS1. Accordingly, erase control transistors may be omitted to increase integration of semiconductor devices, and leakage currents may be reduced to improve reliability of semiconductor devices.

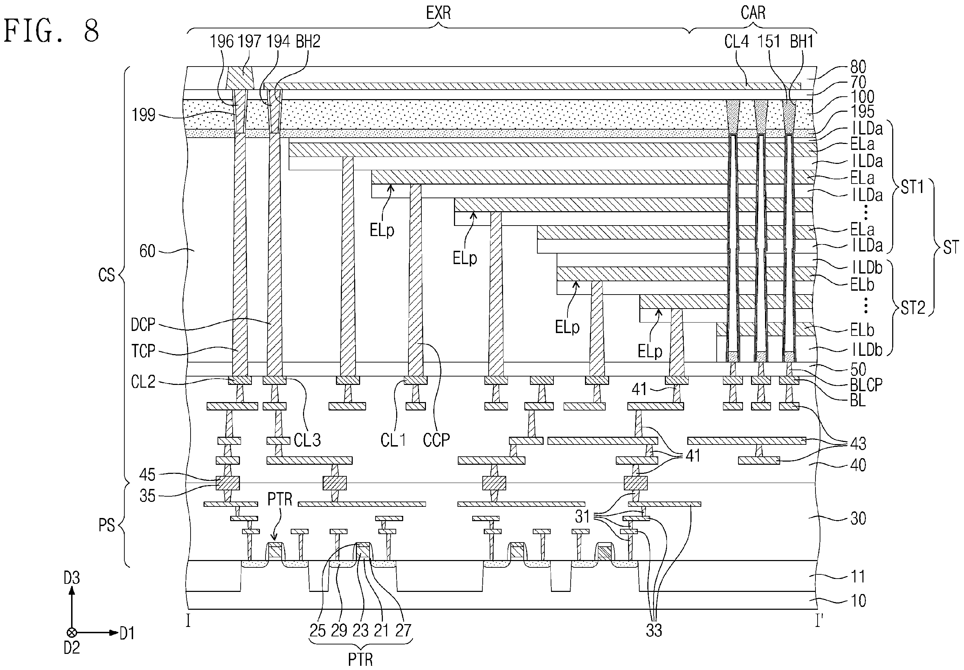

FIG. 8 is a cross-sectional view taken along line I-I' of FIG. 5 according to some embodiments of the present inventive concepts. A description of duplicate components may be omitted in the interest of brevity.

In the present embodiment, the source contact plug DCP may be spaced apart from the stack structure ST. For example, the source contact plug DCP may not penetrate the stack structure ST. The source contact plug DCP may penetrate the fourth interlayer dielectric layer 60 to come into connection with the second source via 194.

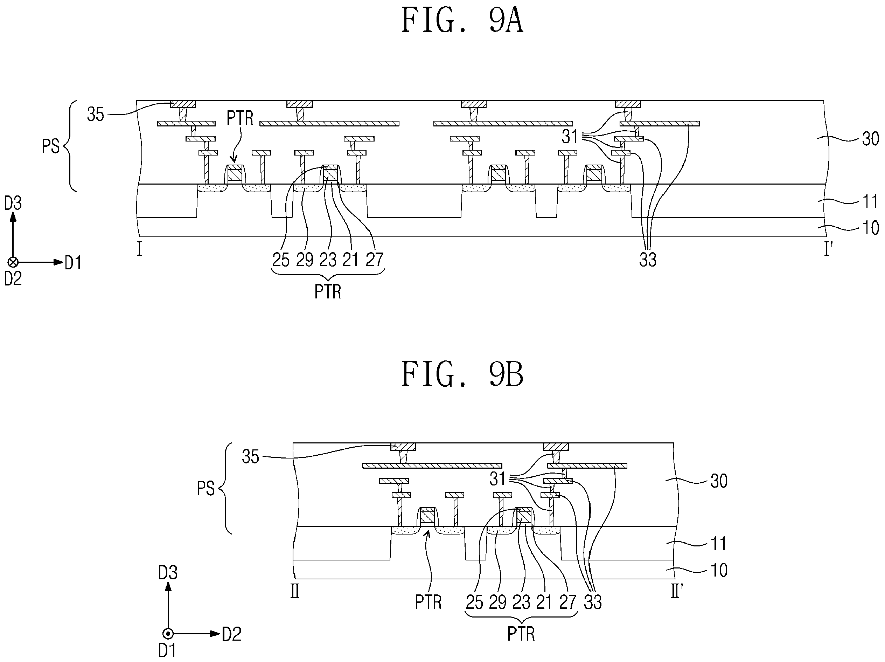

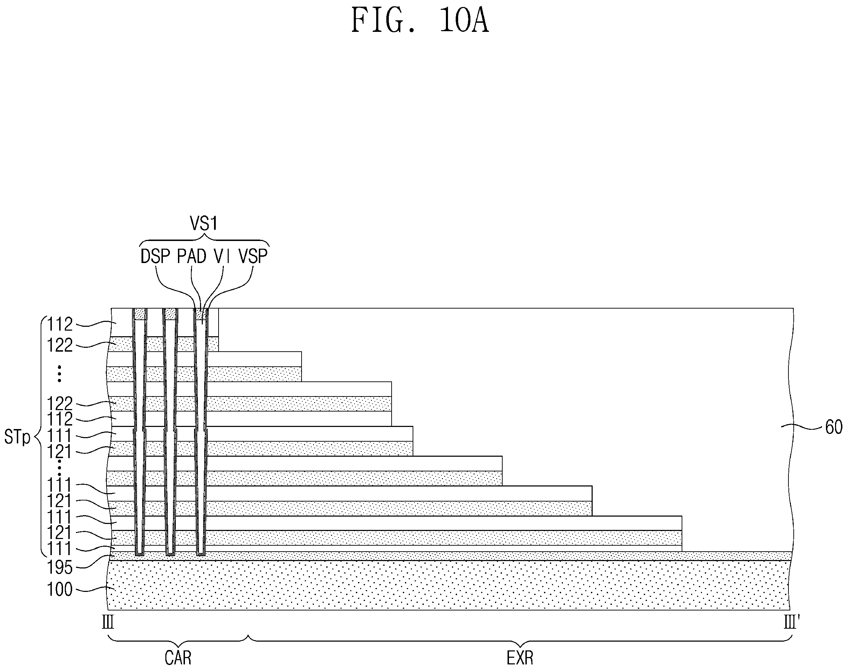

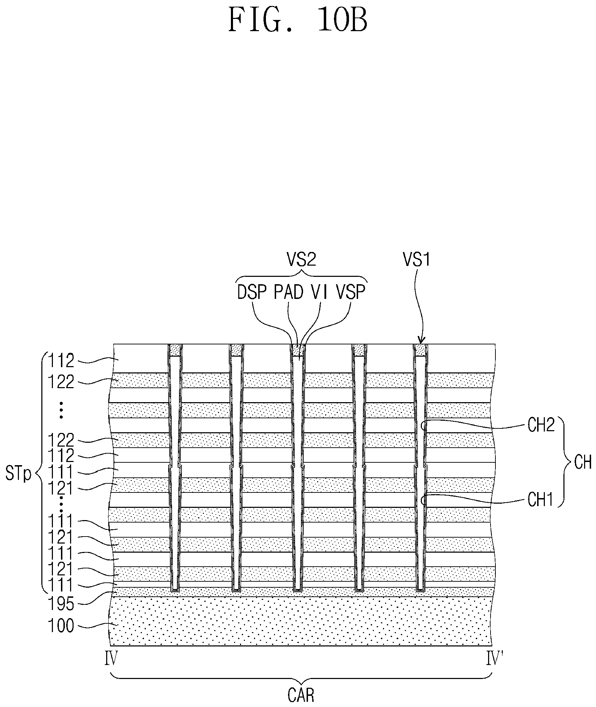

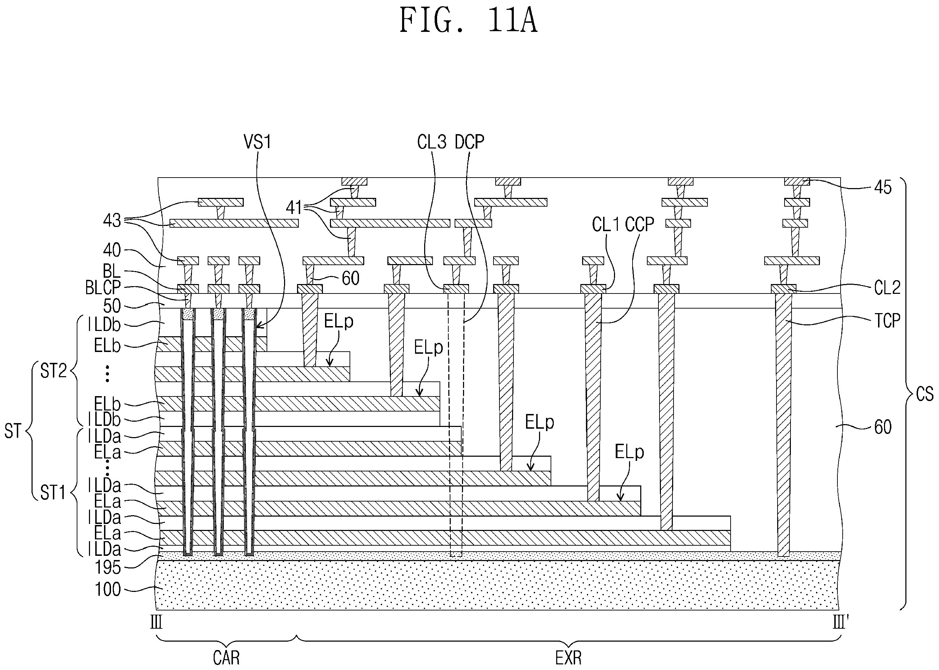

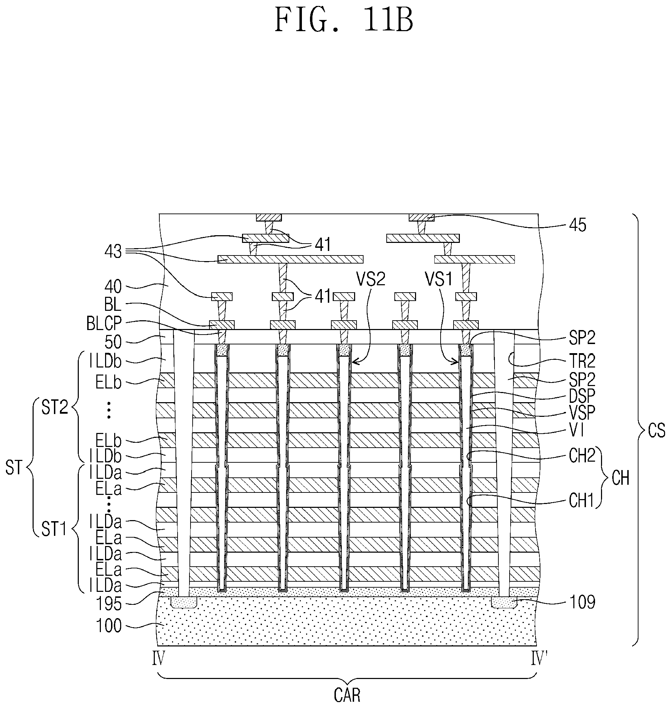

FIGS. 9A and 12A, 13A, 14A and 15A are cross-sectional views taken along line I-I' of FIG. 5, illustrating a method of fabricating a three-dimensional semiconductor memory device according to some embodiments of the present inventive concepts. FIGS. 9B and 12B, 13B, 14B and 15B are cross-sectional views taken along line II-II' of FIG. 5, illustrating a method of fabricating a three-dimensional semiconductor memory device according to some embodiments of the present inventive concepts. FIGS. 10A and 11A are cross-sectional views taken along line III-III' of FIG. 5, illustrating a method of fabricating a three-dimensional semiconductor memory device according to some embodiments of the present inventive concepts. FIGS. 10B and 11B are cross-sectional views taken along line IV-IV' of FIG. 5, illustrating a method of fabricating a three-dimensional semiconductor memory device according to some embodiments of the present inventive concepts.

Referring to FIGS. 9A and 9B, a peripheral circuit structure PS may be formed on a first substrate 10. The formation of the peripheral circuit structure PS may include forming a device isolation layer 11 in the first substrate 10, forming peripheral transistors PTR on an active region of the first substrate 10 defined by the device isolation layer 11, forming peripheral contact plugs 31, peripheral circuit lines 33, and first bonding pads 35 that are electrically connected to the peripheral transistors PTR, and forming a first interlayer dielectric layer 30 that covers the peripheral contact plugs 31, the peripheral circuit lines 33, and the first bonding pads 35.

The first bonding pads 35 may have their top surfaces substantially coplanar with that of the first interlayer dielectric layer 30. In this description below, the phrase "substantially coplanar with" may mean that a planarization process can be performed. The planarization process may include, for example, a chemical mechanical polishing (CMP) process or an etch-back process.

Referring to FIGS. 10A and 10B, an etch stop layer 195 may be formed on a second substrate 100. The etch stop layer 195 may include, for example, one of an aluminum oxide layer, a titanium oxide layer, and a tantalum oxide layer. First interlayer dielectric layers 111 and first sacrificial layers 121 may be alternately stacked on the etch stop layer 195. Afterwards, first vertical channel holes CH1 may be formed to penetrate the first interlayer dielectric layers 111 and the first sacrificial layers 121, and the first vertical channel holes CH1 may be filled with sacrificial layers. The first vertical channel holes CH1 may exposed the etch stop layer 195.

Second interlayer dielectric layers 112 and second sacrificial layers 122 may be alternately stacked on the first vertical channel holes CH1. In some embodiments, the first and second sacrificial layers 121 and 122 may be formed of a dielectric material different from that of the first and second interlayer dielectric layers 111 and 112. The first and second sacrificial layers 121 and 122 may be formed of a material that can be etched with an etch selectivity with respect to the first and second interlayer dielectric layers 111 and 112. For example, the first and second sacrificial layers 121 and 122 may be formed of silicon nitride, and the first and second interlayer dielectric layers 111 and 112 may be formed of silicon oxide. The first and second sacrificial layers 121 and 122 may have substantially the same thickness, and the first and second interlayer dielectric layers 111 and 112 may have their thicknesses that are changed on a certain region.

Thereafter, second vertical channel holes CH2 may be formed to penetrate the second interlayer dielectric layers 112 and the second sacrificial layers 122 and to expose the sacrificial layers in the first vertical channel holes CH1. The second vertical channel holes CH2 may overlap in a third direction D3 with the first vertical channel holes CH1, and the second vertical channel holes CH2 and the first vertical channel holes CH1 may be connected to constitute vertical channel holes CH. The sacrificial layers exposed by the second vertical channel holes CH2 may be removed, and then first, second, and third vertical channel structures VS1, VS2, and VS3 may be formed in the vertical channel holes CH. Therefore, a preliminary stack structure STp may be formed which includes the first and second interlayer dielectric layers 111 and 112 and the first and second sacrificial layers 121 and 122 that are alternately stacked.

The formation of each of the first, second, and third vertical channel structures VS1, VS2, and VS3 may be formed by forming a data storage pattern DSP and a vertical semiconductor pattern VSP that conformally cover an inner wall of a corresponding one of the vertical channel holes CH, forming a buried dielectric pattern VI in a space surrounded by the vertical semiconductor pattern VSP, and forming a conductive pad PAD in a space surrounded by the buried dielectric pattern VI and the data storage pattern DSP.

A trimming process may be performed on the preliminary stack structure STp including the first and second interlayer dielectric layers 111 and 112 and the first and second sacrificial layers 121 and 122 that are alternately stacked. The trimming process may include forming a mask pattern that partially covers a top surface of the preliminary stack structure STp on a cell array area CAR and a cell array contact area EXR, using the mask pattern to pattern the preliminary stack structure STp, reducing an area of the mask pattern, and using the reduced mask pattern to pattern the preliminary stack structure STp. The reducing an area of the mask pattern and the using the reduced mask pattern to pattern the preliminary stack structure STp may be alternately repeated.

The trimming process may expose at least a portion of each of the first and second interlayer dielectric layers 111 and 112, and may form the preliminary stack structure STp to have a stepwise structure on the cell array contact area EXR. The stepwise structure of the preliminary stack structure STp may expose a portion of the etch stop layer 195. Afterwards, a fourth interlayer dielectric layer 60 may be formed to cover the stepwise structure of the preliminary stack structure STp. For example, the fourth interlayer dielectric layer 60 may include silicon oxide.

Referring to FIGS. 5, 11A, and 11B, a third interlayer dielectric layer 50 may be formed to cover a top surface of the fourth interlayer dielectric layer 60. First and second trenches TR1 and TR2 may be formed to penetrate the third interlayer dielectric layer 50, the preliminary stack structure STp, and at least a portion of the etch stop layer 195. The first and second trenches TR1 and TR2 may extend from the cell array area CAR toward the cell array contact area EXR. The first trench TR1 may have a depth less than that of the second trench TR2. The first trench TR1 may have a bottom surface located at a higher level than that of a top surface of a topmost one of the first interlayer dielectric layers 111. The second trench TR2 may have a bottom surface located at a lower level than those of bottom surfaces of the first, second, and third vertical channel structures VS1, VS2, and VS3.

The first and second sacrificial layers 121 and 122 may be removed which are exposed by the first and second trenches TR1 and TR2. The removal of the first and second sacrificial layers 121 and 122 may include performing, for example, a wet etching process that uses hydrofluoric acid (HF) and/or phosphoric acid (H₃PO₄). The first and second sacrificial layers 121 and 122 may partially remain without being completely removed on the cell array contact area EXR.

First and second conductive patterns ELa and ELb may be formed to fill spaces where the first and second sacrificial layers 121 and 122 are removed. The first and second interlayer dielectric layers 111 and 112 may be called first and second interlayer dielectric layers ILDa and ILDb of first and second stack structures ST1 and ST2, and as a result a stack structure ST may be formed to include the first and second interlayer dielectric layers ILDa and ILDb and the first and second conductive patterns ELa and ELb.

A first separation pattern SP1 may be formed to fill the first trench TR1, and a second separation pattern SP2 may be formed to fill the second trench TR2. The first and second separation patterns SP1 and SP2 may have their top surfaces substantially coplanar with that of the third interlayer dielectric layer 50.

On the cell array area CAR, bit-line contact plugs BLCP may be formed to penetrate the third interlayer dielectric layer 50 to come into contact with top surfaces of the first and second vertical channel structures VS1 and VS2. In some embodiments, the bit-line contact plugs BLCP may not be formed on the second vertical channel structures VS2.

On the cell array contact area EXR, cell contact plugs CCP may be formed to penetrate the third and fourth interlayer dielectric layers 50 and 60 to come into contact with pad parts ELp of the first and second conductive patterns ELa and ELb. The cell contact plugs CCP may penetrate at least portions of the first and second interlayer dielectric layers ILDa and ILDb. On the cell array contact area EXR, a through contact plug TCP may be formed to penetrate the third and fourth interlayer dielectric layers 50 and 60 to come into connection with the etch stop layer 195. On the cell array contact area EXR, a source contact plug DCP may be formed to penetrate the stack structure ST to come into connection with the etch stop layer 195. For example, the source contact plug DCP may be formed to penetrate portions, which remain on the cell array contact area EXR, of the first and second interlayer dielectric layers 111 and 112 and the first and second sacrificial layers 121 and 122, and thus the source contact plug DCP may be electrically separated (e.g., electrically insulated) from the first and second conductive patterns ELa and ELb.

One or more of the cell contact plugs CCP, the source contact plug DCP, and the through contact plug TCP may be formed together with each other. The formation of the cell contact plugs CCP, the source contact plug DCP, and the through contact plug TCP may include performing an etching process for forming high-aspect ratio holes that penetrate the third and fourth interlayer dielectric layers 50 and 60.

On the cell array area CAR, bit lines BL may be formed on the third interlayer dielectric layer 50 to come into contact with the bit-line contact plugs BLCP. On the cell array contact area EXR, first, second, and third conductive lines CL1, CL2, and CL3 may be formed on the third interlayer dielectric layer 50.

Connection contact plugs 41, connection circuit lines 43, and second bonding pads 45 may be formed on the third interlayer dielectric layer 50 to come into electrical connection with the bit lines BL and the first and second conductive lines CL1 and CL2, and a second interlayer dielectric layer 40 may be formed on the third interlayer dielectric layer 50 to cover the connection contact plugs 41, the connection circuit lines 43, and the second bonding pads 45. The second bonding pads 45 may have their top surfaces substantially coplanar with that of the second interlayer dielectric layer 40. Therefore, a cell array structure CS may be formed on the second substrate 100.

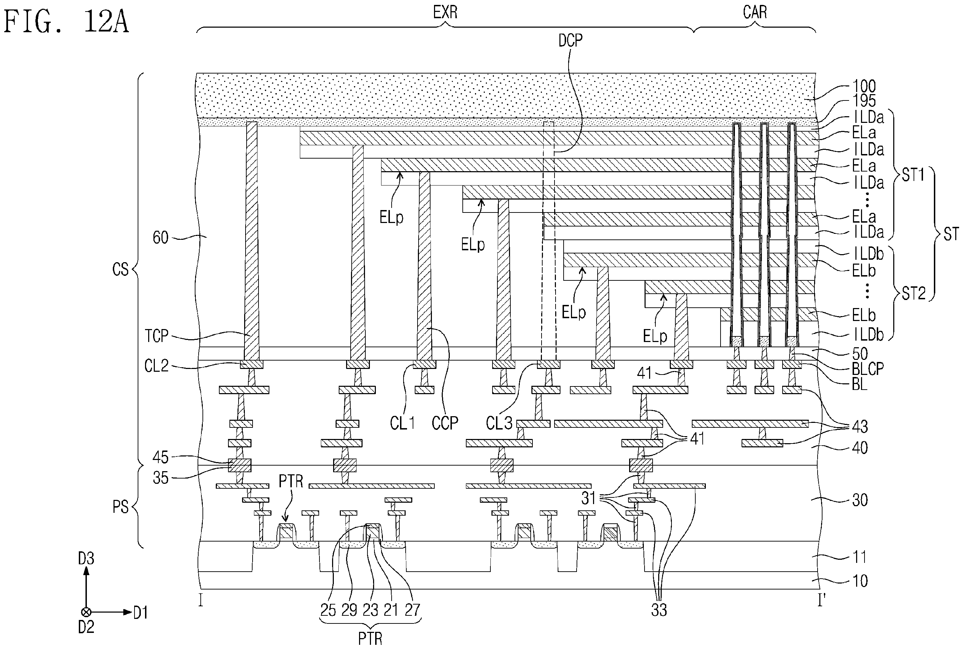

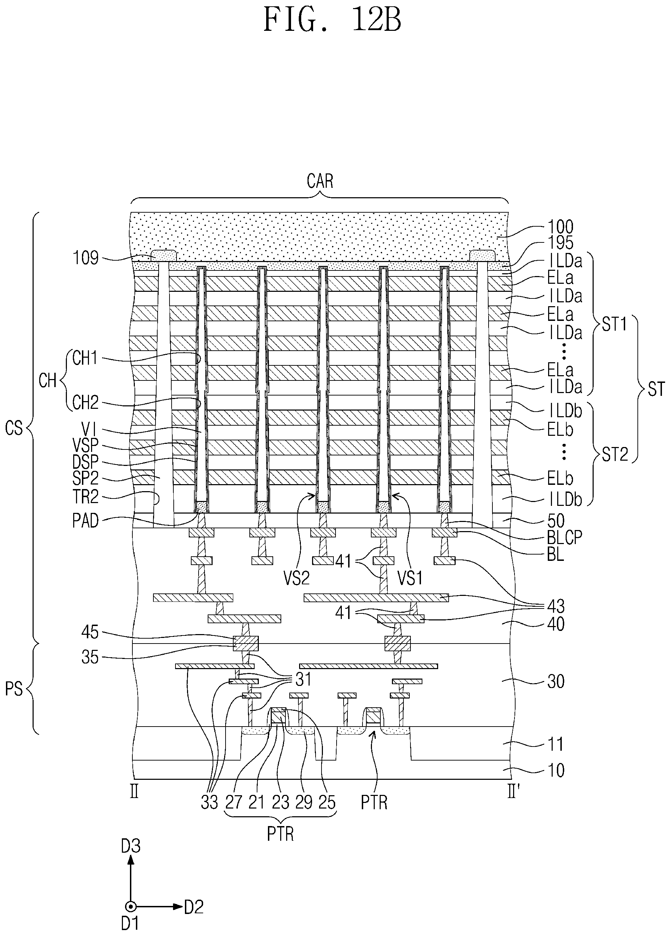

Referring to FIGS. 12A and 12B, the cell array structure CS formed on the second substrate 100 may be bonded to the peripheral circuit structure PS formed on the first substrate 10 through the method discussed with reference to FIGS. 9A and 9B. For example, the cell array structure CS may be attached onto the peripheral circuit structure PS to allow a first surface of the first substrate 10 on which the peripheral circuit structure PS is formed to face a first surface of the second substrate 100 on which the cell array structure CS is formed.

The second substrate 100 may be provided on the first substrate 10 to allow the cell array structure CS to face the peripheral circuit structure PS. The first bonding pads 35 of the peripheral circuit structure PS and the second bonding pads 45 of the cell array structure CS may be merged while being in contact with each other. After the bonding of the first and second bonding pads 35 and 45, an upper portion of the second substrate 100 may be removed. Therefore, the second substrate 100 may have a reduced thickness. A process for removing the upper portion of the second substrate 100 may include, for example, a planarization process, a dry etching process, and/or a wet etching process.

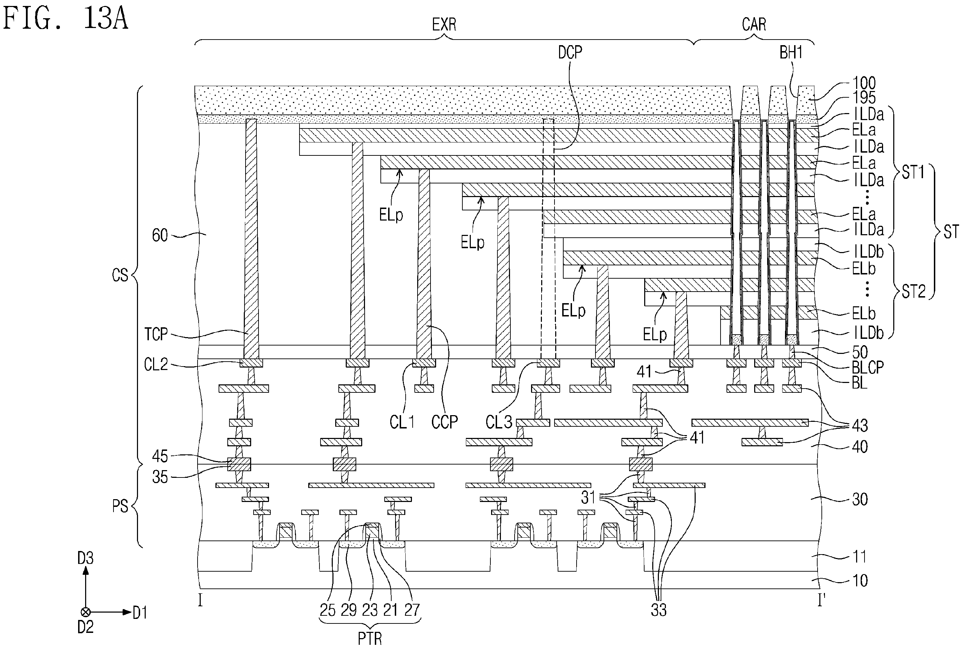

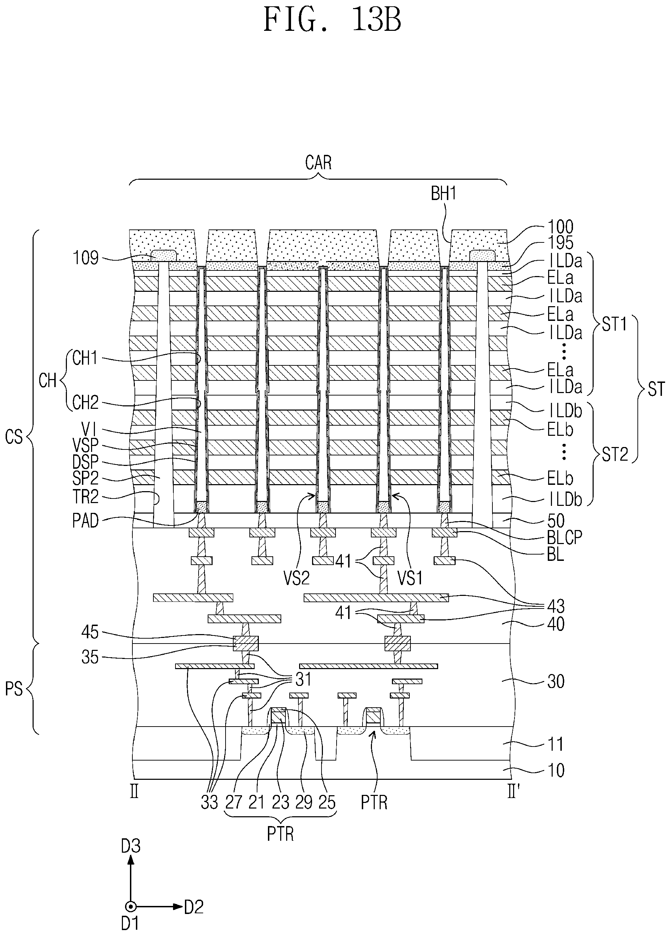

Referring to FIGS. 13A and 13B, first via holes BH1 may be formed to penetrate the second substrate 100. The first via holes BH1 may be formed to align with the first vertical channel structures VS1, and may not be formed on any of the second and third vertical channel structures VS2 and VS3. The first via holes BH1 may expose upper portions of the data storage patterns DSP included in the first vertical channel structures VS1, and the exposed upper portions of the data storage patterns DSP may be removed to expose top surfaces of the vertical semiconductor patterns VSP. The removal of the upper portions of the data storage patterns DSP may be performed concurrently or simultaneously with (e.g., at approximately, but not necessarily exactly, the same time) the etching of the second substrate 100, but in some embodiments, after the etching of the second substrate 100, a separate etching process may be performed to remove the upper portions of the data storage patterns DSP.

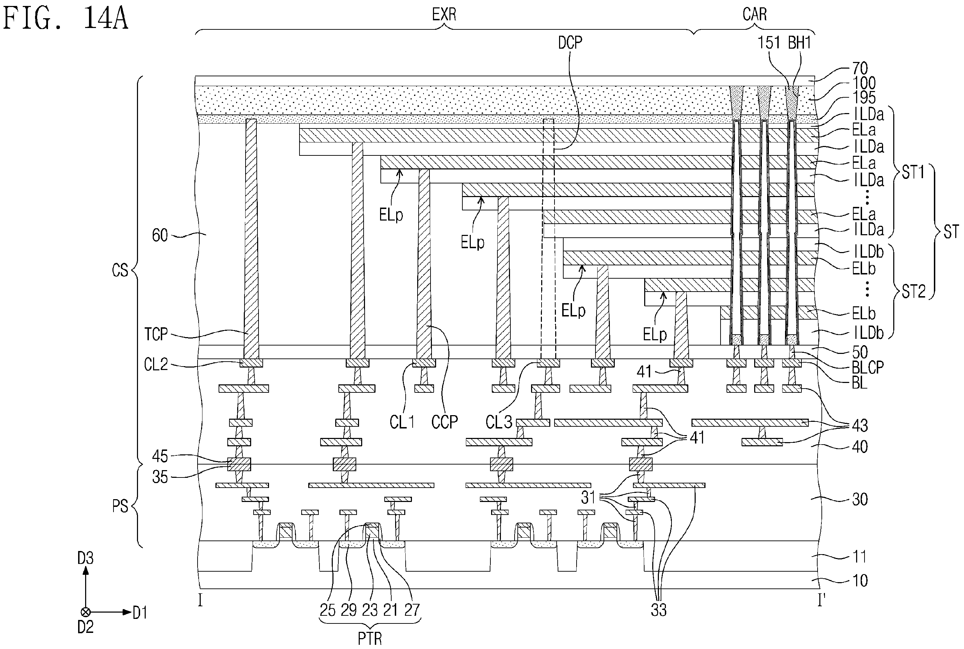

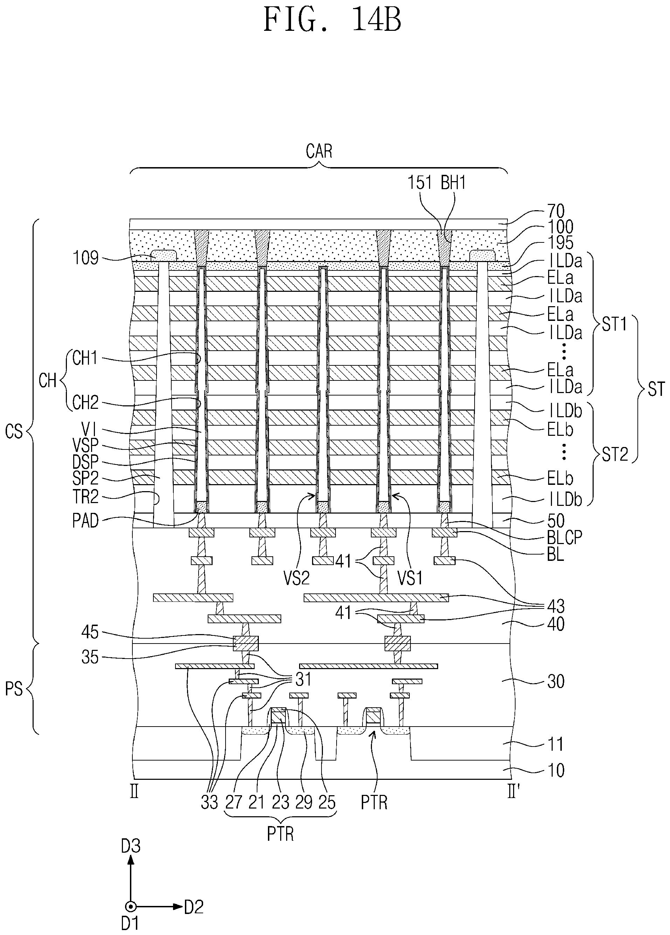

Referring to FIGS. 14A and 14B, connection vias 151 may be formed to fill the first via holes BH1. The connection vias 151 may be formed by, for example, chemical vapor deposition and/or selective epitaxial growth. The connection vias 151 may be formed by forming a polycrystalline silicon layer and then performing an etch-back process. After that, a fifth interlayer dielectric layer 70 may be formed to cover the connection vias 151.

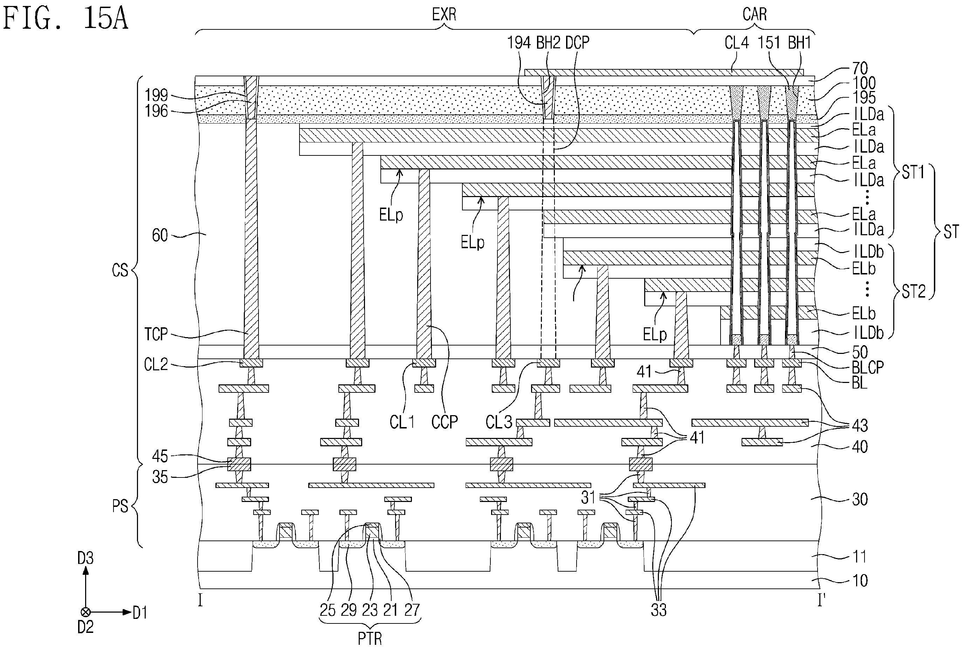

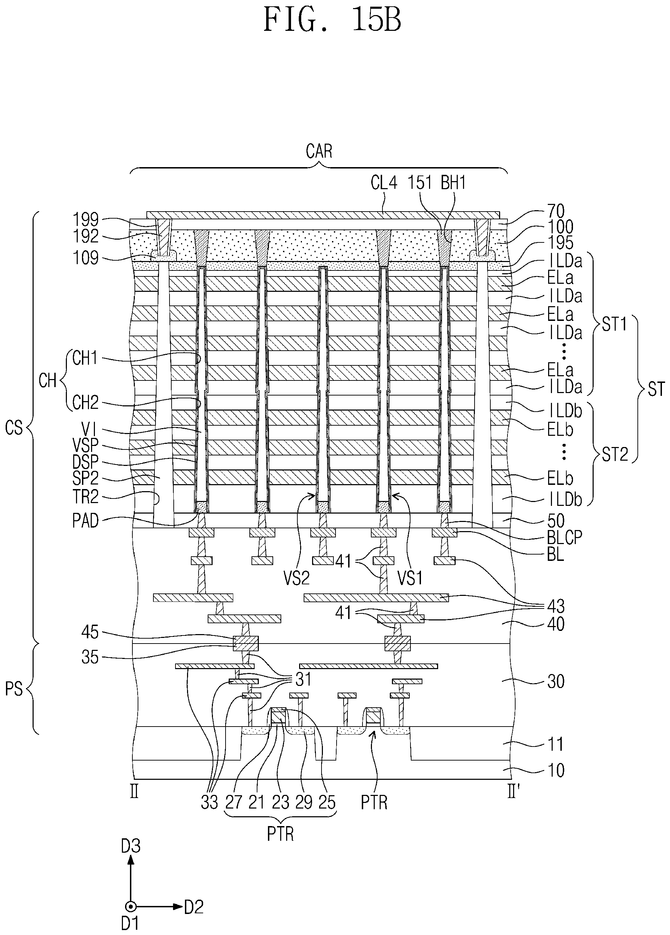

Referring to FIGS. 15A and 15B, second via holes BH2 may be formed to penetrate the fifth interlayer dielectric layer 70 and the second substrate 100. In the second via holes BH2, a first source via 192 may be formed to be connected to the common source region 109, a second source via 194 may be formed to be connected to the source contact plug DCP, and a through via 196 may be formed to be connected to the through contact plug TCP. The first source via 192, the second source via 194, and the through via 196 may be formed of, for example, at least one selected from tungsten, titanium, tantalum, and conductive metal nitride thereof. Afterwards, a common source line CL4 may be formed to connect the first source via 192 and the second source via 194 to each other.

Referring back to FIGS. 5, 6A, and 6B, a backside conductive pattern 197 may be formed on the through via 196. The backside conductive pattern 197 may be formed by forming a metal layer that covers the through via 196, forming a mask pattern that covers the metal layer, and using the mask pattern as an etching mask to pattern the metal layer. As a result, the backside conductive pattern 197 may have a width at its bottom surface greater than a width at its top surface. For example, the backside conductive pattern 197 may be formed of aluminum. After that, a sixth interlayer dielectric layer 80 may be formed to cover the fifth interlayer dielectric layer 70.

According to some embodiments of the present inventive concepts, a bulk erase operation may be possibly performed by a second substrate and connection vias that are respectively connected to vertical semiconductor patterns of first vertical channel structures. Accordingly, erase control transistors may be omitted to increase integration of semiconductor devices, and leakage currents may be reduced to improve reliability of semiconductor devices.

Although terms (e.g., first, second or third) may be used herein to describe various elements, these elements should not be limited by these terms. These terms are only used to distinguish one element from another. For example, a first element may be referred to as a second element, and, similarly a second element may be referred to as a first element without departing from the teachings of the disclosure.

As used herein, an element or region that is "covering" or "surrounding" or "filling" another element or region may completely or partially cover or surround or fill the other element or region. As used herein, "an element A connected to an element B" (or similar language) may mean that the element A is electrically connected to the element B and/or the element A contacts the element B.

Although the present invention has been described in connection with some example embodiments of the present inventive concepts illustrated in the accompanying drawings, it will be understood by one of ordinary skill in the art that variations in form and detail may be made therein without departing from the scope of the present inventive concepts. The above disclosed embodiments should thus be considered illustrative and not restrictive.

## Claims

1. A three-dimensional semiconductor memory device comprising:
a first substrate (10);
a peripheral circuit structure (PS) on the first substrate (10); and
a cell array structure (CS) on the peripheral circuit structure (PS),
wherein the cell array structure (CS) includes:
a second substrate (100);
a stack structure (ST) between the second substrate (100) and the peripheral circuit structure (PS), the stack structure (ST) including a plurality of interlayer dielectric layers (30, 40, 50, 60, 70, 80) and a plurality of conductive patterns (Ela, ELb) that are stacked alternately with the plurality of interlayer dielectric layers (30, 40, 50, 60, 70, 80);
a plurality of vertical channel structures (VS 1, VS2) that include respective portions in the stack structure (ST) and include a plurality of vertical semiconductor patterns (VSP), respectively; and
a plurality of connection vias (151) that include respective portions in the second substrate (100) and are connected to respective top surfaces of the plurality of vertical semiconductor patterns (VSP).

2. The three-dimensional semiconductor memory device of claim 1, wherein the plurality of connection vias include a semiconductor material.

3. The three-dimensional semiconductor memory device of claim 1 or 2, wherein the plurality of connection vias include a polycrystalline silicon layer having a first conductivity type.

4. The three-dimensional semiconductor memory device of any preceding claim, wherein
the cell array structure includes a cell array area and a cell array contact area,
the plurality of vertical channel structures include a plurality of first vertical channel structures on the cell array area and a plurality of second vertical channel structures on the cell array contact area, and
the plurality of connection vias overlap the plurality of first vertical channel structures, respectively, and do not overlap the plurality of second vertical channel structures.

5. The three-dimensional semiconductor memory device of any preceding claim, wherein
the plurality of vertical channel structures include, respectively, a plurality of buried dielectric patterns that are surrounded by the plurality of vertical semiconductor patterns, respectively,
the plurality of vertical semiconductor patterns include:
a plurality of first parts that extend on respective sidewalls of the plurality of buried dielectric patterns; and
a plurality of second parts that extend on respective top surfaces of the plurality of buried dielectric patterns, and
the plurality of connection vias are in contact with the plurality of second parts, respectively.

6. The three-dimensional semiconductor memory device of any preceding claim, wherein
the plurality of vertical channel structures include, respectively, a plurality of buried dielectric patterns that are surrounded by the plurality of vertical semiconductor patterns, respectively, and
the plurality of connection vias contact respective top surfaces of the plurality of buried dielectric patterns and the respective top surfaces of the plurality of vertical semiconductor patterns.

7. The three-dimensional semiconductor memory device of any preceding claim, wherein at least one of the plurality of connection vias include a void or seam therein.

8. The three-dimensional semiconductor memory device of any preceding claim, wherein the cell array structure further includes an etch stop layer between the second substrate and the stack structure.

9. The three-dimensional semiconductor memory device of claim 8, wherein the etch stop layer includes a metal oxide layer.

10. The three-dimensional semiconductor memory device of claim 8 or 9, wherein an interface between one of the plurality of connection vias and one of the plurality of vertical semiconductor patterns is in the etch stop layer.

11. The three-dimensional semiconductor memory device of any preceding claim, wherein the cell array structure further includes a common source region in the second substrate, the common source region having a second conductivity type.

12. The three-dimensional semiconductor memory device of claim 11, wherein the cell array structure further includes:
a common source line on the second substrate; and
a source via that connects the common source line to the common source region, the source via being in the second substrate.
